# EUROPÄISCHE PATENTSCHRIFT

(11) **EP 3 751 960 B1**
(45) Veröffentlichungstag und Bekanntmachung des Hinweises auf die Patenterteilung: **27.04.2022**
(21) Anmeldenummer: 20184104.6
(22) Anmeldetag: 17.04.2012
(51) Int. Cl.: H05B 3/84, H01R 4/62

(54) **SCHEIBE MIT EINEM ELEKTRISCHEN ANSCHLUSSELEMENT**
PANE WITH ELECTRIC CONNECTION ELEMENT
VITRE DOTÉE D'UN ÉLÉMENT DE RACCORDEMENT ÉLECTRIQUE

(30) Priorität: 10.05.2011 EP 11165504; 10.05.2011 EP 11165506
(43) Veröffentlichungstag der Anmeldung: 16.12.2020
(62) Teilanmeldung aus: 19152140.0
(73) Patentinhaber: SAINT-GOBAIN GLASS FRANCE, 92400 Courbevoie (FR)
(72) Erfinder: DEGEN, Christoph, 47918 Tönisvörst (DE); REUL, Bernhard, 52134 Herzogenrath (DE); RATEICZAK, Mitja, 52146 Würselen (DE); SCHLARB, Andreas, 42287 Wuppertal (DE); LESMEISTER, Lothar, 6373 Landgraaf (NL)
(74) Vertreter: Gebauer, Dieter Edmund

(56) Entgegenhaltungen:
- EP-A1- 1 488 972
- EP-A2- 1 942 703
- WO-A1-2004/068643
- WO-A1-2007/110610
- DE-U1-202008 015 441
- JP-U- H0 658 557

## Beschreibung

Die Erfindung betrifft eine Scheibe mit einem elektrischen Anschlusselement und ein wirtschaftliches und umweltfreundliches Verfahren zu deren Herstellung.

Die Erfindung betrifft weiter eine Scheibe mit einem elektrischen Anschlusselement für Fahrzeuge mit elektrisch leitfähigen Strukturen wie beispielsweise Heizleiter oder Antennenleiter. Die elektrisch leitfähigen Strukturen sind üblicherweise über angelötete elektrische Anschlusselemente mit der Bordelektrik verbunden. Aufgrund unterschiedlicher thermischer Ausdehnungskoeffizienten der verwendeten Materialien treten mechanische Spannungen bei der Herstellung und im Betrieb auf, welche die Scheiben belasten und den Bruch der Scheibe hervorrufen können.

Bleihaltige Lote weisen eine hohe Duktilität auf, die auftretende mechanische Spannungen zwischen elektrischem Anschlusselement und der Scheibe durch plastische Deformierung kompensieren können. Allerdings müssen aufgrund der Altauto-Richtlinie 2000/53/EG innerhalb der EG bleihaltige Lote durch bleifreie Lote ersetzt werden. Die Richtlinie wird zusammenfassend mit dem Kürzel ELV (End of life vehicles) bezeichnet. Das Ziel ist dabei, im Zuge der massiven Ausweitung von Wegwerfelektronik äußerst problematische Bestandteile aus den Produkten zu verbannen. Die betroffenen Substanzen sind Blei, Quecksilber und Cadmium. Das betrifft unter anderem die Durchsetzung von bleifreien Lötmitteln in elektrischen Anwendungen auf Glas und die Einführung entsprechender Ersatzprodukte hierzu.

EP 1 942 703 A2 offenbart ein elektrisches Anschlusselement an Scheiben von Fahrzeugen, wobei die Differenz der thermischen Ausdehnungskoeffizienten von Scheibe und elektrischem Anschlusselement < 5 x 10⁻⁶/°C beträgt und das Anschlusselement überwiegend Titan enthält. Um eine ausreichende mechanische Stabilität und Prozessierbarkeit zu ermöglichen wird vorgeschlagen, einen Lotmassenüberschuss zu verwenden. Der Überschuss an Lotmasse tritt aus dem Zwischenraum zwischen dem Anschlusselement und elektrisch leitfähiger Struktur heraus. Der Überschuss an Lotmasse verursacht hohe mechanische Spannungen in der Glasscheibe. Diese mechanischen Spannungen führen schließlich zum Bruch der Scheibe.

WO 2004/068643 A1 offenbart eine Scheibe mit einem Substrat und einem Anschlusselement, wobei das Anschlusselement einen ersten und einen zweiten Fußbereich, einen ersten und einen zweiten Übergangsbereich und einen Brückenbereich zwischen dem ersten und zweiten Übergangsbereich enthält, und wobei der Winkel zwischen der Oberfläche des Substrats und jeder der Tangentialebenen der zum Substrat hingewandten Flächen der Übergangsbereiche <90° beträgt. Die Aufgabe der vorliegenden Erfindung ist es, eine Scheibe mit einem elektrischen Anschlusselement und ein wirtschaftliches und umweltfreundliches Verfahren zu deren Herstellung bereitzustellen, wobei kritische mechanische Spannungen in der Scheibe vermieden werden.

Die Aufgabe der vorliegenden Erfindung wird erfindungsgemäß durch eine Vorrichtung gemäß dem unabhängigen Anspruch 1 gelöst. Bevorzugte Ausführungen gehen aus den Unteransprüchen hervor.

Die erfindungsgemäße Scheibe mit einem elektrischen Anschlusselement umfasst die folgenden Merkmale:
- ein Substrat,
- eine elektrisch leitfähige Struktur auf einem Bereich des Substrats,
- eine Schicht einer Lotmasse auf einem Bereich der elektrisch leitfähigen Struktur und
- ein Anschlusselement auf der Lotmasse, wobei
- das Anschlusselement einen ersten und einen zweiten Fußbereich, einen ersten und einen zweiten Übergangsbereich und einen Brückenbereich zwischen dem ersten und zweiten Übergangsbereich enthält,
- sich an der Unterseite des ersten und zweiten Fußbereichs eine erste und eine zweite Kontaktfläche befinden,
- die erste und zweite Kontaktfläche und die zum Substrat hingewandten Flächen des ersten und zweiten Übergangsbereichs durch die Lotmasse mit der elektrisch leitfähigen Struktur verbunden sind und,
- der Winkel zwischen der Oberfläche des Substrats und jeder der Tangentialebenen der zum Substrat hingewandten Flächen der Übergangsbereiche < 90° beträgt.

Auf der Scheibe ist eine elektrisch leitfähige Struktur aufgebracht. Ein elektrisches Anschlusselement ist mit einer Lotmasse auf Teilbereichen mit der elektrisch leitfähigen Struktur elektrisch verbunden. Dabei sind die erste Kontaktfläche und die zum Substrat hingewandte Fläche des ersten Übergangsbereichs mit einem ersten Teilbereich der elektrisch leitfähigen Struktur verbunden. Die zweite Kontaktfläche und die zum Substrat hingewandte Fläche des zweiten Übergangsbereichs sind mit einem zweiten Teilbereich der elektrisch leitfähigen Struktur verbunden. Die Lotmasse tritt mit einer Austrittsbreite von < 1 mm aus dem Zwischenraum zwischen dem Anschlusselement und der elektrisch leitfähigen Struktur aus.

In einer bevorzugten Ausgestaltung ist die maximale Austrittsbreite bevorzugt kleiner 0,5 mm und insbesondere etwa 0 mm. Das ist besonders vorteilhaft im Hinblick auf die Reduzierung von mechanischen Spannungen in der Scheibe, die Haftung des Anschlusselements und die Einsparung des Lots.

Die maximale Austrittsbreite ist definiert als der Abstand zwischen den Außenkanten des Anschlusselementes und der Stelle des Lotmasseübertritts, an dem die Lotmasse eine Schichtdicke von 50 µm unterschreitet. Die maximale Austrittsbreite wird nach dem Lötvorgang an der erstarrten Lotmasse gemessen.

Eine gewünschte maximale Austrittsbreite wird durch eine geeignete Wahl von Lotmassenvolumen und lotrechtem Abstand zwischen Anschlusselement und elektrisch leitfähiger Struktur erreicht, was durch einfache Versuche ermittelt werden kann. Der lotrechte Abstand zwischen Anschlusselement und elektrisch leitfähiger Struktur kann durch ein entsprechendes Prozesswerkzeug, beispielsweise ein Werkzeug mit einem integrierten Abstandshalter, vorgegeben werden.

Die maximale Austrittsbreite kann auch negativ sein, also in den von elektrischem Anschlusselement und elektrisch leitfähiger Struktur gebildeten Zwischenraum zurückgezogen sein.

In einer vorteilhaften Ausgestaltung der erfindungsgemäßen Scheibe ist die maximale Austrittsbreite in dem vom elektrischen Anschlusselement und der elektrisch leitfähigen Struktur gebildeten Zwischenraum in einem konkaven Meniskus zurückgezogen. Ein konkaver Meniskus entsteht beispielsweise durch Erhöhen des lotrechten Abstands zwischen Abstandshalter und leitfähiger Struktur beim Lötvorgang, während das Lot noch flüssig ist.

Die Lotmasse wird nach dem Stand der Technik beim Verlöten des Anschlusselements mit der elektrisch leitfähigen Struktur aufgeschmolzen. Anschließend wird der gewünschte Abstand zwischen der Kontaktfläche des Anschlusselements und der elektrisch leitfähigen Struktur eingestellt. Dabei tritt überschüssige flüssige Lotmasse unkontrolliert aus dem Zwischenraum zwischen Anschlusselement und elektrisch leitfähiger Struktur aus. Der unkontrollierte Lotmasseübertritt über die Außenkanten des Anschlusselements führt zu einer großen maximalen Austrittsbreite. Dies führt zu kritischen mechanischen Spannungen in der Scheibe.

Der Vorteil des erfindungsgemäßen Anschlusselements liegt in der Wirkung des Kapillareffekts zwischen elektrisch leitfähiger Struktur und den Übergangsbereichen des Anschlusselements. Der Kapillareffekt ist eine Folge des geringen Abstands zwischen den Übergangsbereichen des Anschlusselements und der elektrisch leitfähigen Struktur. Der geringe Abstand ergibt sich aus dem Winkel < 90° zwischen der Oberfläche des Substrats und der Tangentialebenen der zum Substrat hingewandten Flächen der Übergangsbereiche. Der gewünschte Abstand zwischen Anschlusselement und elektrisch leitfähiger Struktur wird nach dem Aufschmelzen der Lotmasse eingestellt. Überschüssige Lotmasse wird durch den Kapillareffekt kontrolliert in das vom Übergangsbereich und der elektrisch leitfähigen Struktur begrenzte Volumen gesaugt. Dadurch wird der Lotmasseübertritt an den Außenkanten des Anschlusselements und damit die maximale Austrittsbreite verringert. Durch das erfindungsgemäße Anschlusselement wird somit eine Reduzierung der mechanischen Spannungen in der Scheibe erreicht. Das ist insbesondere bei der Verwendung einer bleifreien Lotmasse vorteilhaft, die aufgrund ihrer geringeren Duktilität im Vergleich zu bleihaltigen Lotmassen mechanische Spannungen weniger gut kompensieren kann.

Im Sinne der Definition der maximalen Austrittsbreite sind die Kanten der Kontaktflächen, an welche die Übergangsbereiche angeschlossen sind, keine Außenkanten des Anschlusselements.

Der Hohlraum, der durch die elektrisch leitfähige Struktur, die Übergangsbereiche und den Brückenbereich begrenzt wird, kann vollständig mit Lotmasse gefüllt sein. Bevorzugt ist der Hohlraum nicht vollständig mit Lotmasse gefüllt.

Das Substrat enthält bevorzugt Glas, besonders bevorzugt Flachglas, Floatglas, Quarzglas, Borosilikatglas, Kalk-Natron-Glas. In einer alternativen bevorzugten Ausgestaltung enthält das Substrat Polymere, besonders bevorzugt Polyethylen, Polypropylen, Polycarbonat, Polymethylmethacrylat und / oder Gemische davon.

Das Substrat weist einen ersten thermischen Ausdehnungskoeffizienten auf. Das Anschlusselement weist einen zweiten thermischen Ausdehnungskoeffizienten auf.

Der erste thermische Ausdehnungskoeffizient ist bevorzugt von 8 × 10⁻⁶/°C bis 9 × 10⁻⁶/°C. Das Substrat enthält bevorzugt Glas, das bevorzugt einen thermischen Ausdehnungskoeffizienten von 8,3 × 10⁻⁶/°C bis 9 × 10⁻⁶/°C in einem Temperaturbereich von 0 °C bis 300 °C aufweist.

Das erfindungsgemäße Anschlusselement enthält bevorzugt zumindest eine Eisen-Nickel-Legierung, eine Eisen-Nickel-Kobalt-Legierung oder eine Eisen-Chrom-Legierung.

Das erfindungsgemäße Anschlusselement enthält bevorzugt zumindest 50 Gew.-% bis 89,5 Gew.-% Eisen, 0 Gew.-% bis 50 Gew.-% Nickel, 0 Gew.-% bis 20 Gew.-% Chrom, 0 Gew.-% bis 20 Gew.-% Kobalt, 0 Gew.-% bis 1,5 Gew.-% Magnesium, 0 Gew.-% bis 1 Gew.-% Silizium, 0 Gew.-% bis 1 Gew.-% Kohlenstoff, 0 Gew.-% bis 2 Gew.-% Mangan, 0 Gew.-% bis 5 Gew.-% Molybdän, 0 Gew.-% bis 1 Gew.-% Titan, 0 Gew.-% bis 1 Gew.-% Niob, 0 Gew.-% bis 1 Gew.-% Vanadium, 0 Gew.-% bis 1 Gew.-% Aluminium und / oder 0 Gew.-% bis 1 Gew.-% Wolfram.

In einer vorteilhaften Ausgestaltung der Erfindung ist die Differenz zwischen dem ersten und dem zweiten Ausdehnungskoeffizienten ≥ 5 × 10⁻⁶/°C. Der zweite thermische Ausdehnungskoeffizient ist dabei bevorzugt von 0,1 × 10⁻⁶/°C bis 4 × 10⁻⁶/°C, besonders bevorzugt von 0,3 × 10⁻⁶/°C bis 3 × 10⁻⁶/°C in einem Temperaturbereich von 0 °C bis 300 °C.

Das erfindungsgemäße Anschlusselement enthält bevorzugt zumindest 50 Gew.-% bis 75 Gew.-% Eisen, 25 Gew.-% bis 50 Gew.-% Nickel, 0 Gew.-% bis 20 Gew.-% Kobalt, 0 Gew.-% bis 1,5 Gew.-% Magnesium, 0 Gew.-% bis 1 Gew.-% Silizium, 0 Gew.-% bis 1 Gew.-% Kohlenstoff und / oder 0 Gew.-% bis 1 Gew.-% Mangan.

Das erfindungsgemäße Anschlusselement enthält bevorzugt Chrom, Niob, Aluminium, Vanadium, Wolfram und Titan mit einem Anteil von 0 Gew.-% bis 1 Gew.-%, Molybdän mit einem Anteil von 0 Gew.-% bis 5 Gew.-% sowie herstellungsbedingte Beimengungen.

Das erfindungsgemäße Anschlusselement enthält bevorzugt zumindest 55 Gew.-% bis 70 Gew.-% Eisen, 30 Gew.-% bis 45 Gew.-% Nickel, 0 Gew.-% bis 5 Gew.-% Kobalt, 0 Gew.-% bis 1 Gew.-% Magnesium, 0 Gew.-% bis 1 Gew.-% Silizium und / oder 0 Gew.-% bis 1 Gew.-% Kohlenstoff.

Das erfindungsgemäße Anschlusselement enthält bevorzugt Invar (FeNi).

Invar ist eine Eisen-Nickel-Legierung mit einem Gehalt von beispielsweise 36 Gew.-% Nickel (FeNi36). Es ist eine Gruppe von Legierungen und Verbindungen, welche die Eigenschaft aufweisen, in bestimmten Temperaturbereichen anomal kleine oder zum Teil negative Wärmeausdehnungskoeffizienten zu haben. Fe65Ni35 Invar enthält 65 Gew.-% Eisen und 35 Gew.-% Nickel. Bis zu 1 Gew.-% Magnesium, Silizium und Kohlenstoff werden üblicherweise legiert, um die mechanischen Eigenschaften zu verändern. Durch Legieren von 5 Gew.-% Kobalt kann der thermische Ausdehnungskoeffizient weiter reduziert werden. Eine Bezeichnung für die Legierung ist Inovco, FeNi33Co4.5 mit einem Ausdehnungskoeffizienten (20 °C bis 100 °C) von 0,55 × 10⁻⁶/°C.

Wird eine Legierung wie Invar mit einem sehr geringen absoluten thermischen Ausdehnungskoeffizienten von < 4 × 10⁻⁶/°C verwendet, findet eine Überkompensation der mechanischen Spannungen durch unkritische Druckspannungen im Glas oder durch unkritische Zugspannungen in der Legierung statt.

In einer weiteren vorteilhaften Ausgestaltung der Erfindung ist die Differenz zwischen dem ersten und dem zweiten Ausdehnungskoeffizienten < 5 × 10⁻⁶/°C. Durch die geringe Differenz zwischen dem ersten und dem zweiten thermischen Ausdehnungskoeffizienten werden kritische mechanische Spannungen in der Scheibe vermieden und eine bessere Haftung erhalten. Der zweite thermische Ausdehnungskoeffizient ist dabei bevorzugt von 4 × 10⁻⁶/°C bis 8 × 10⁻⁶/°C, besonders bevorzugt von 4 × 10⁻⁶/°C bis 6 × 10⁻⁶/°C in einem Temperaturbereich von 0 °C bis 300 °C.

Das erfindungsgemäße Anschlusselement enthält bevorzugt zumindest 50 Gew.-% bis 60 Gew.-% Eisen, 25 Gew.-% bis 35 Gew.-% Nickel, 15 Gew.-% bis 20 Gew.-% Kobalt, 0 Gew.-% bis 0,5 Gew.-% Silizium, 0 Gew.-% bis 0,1 Gew.-% Kohlenstoff und / oder 0 Gew.-% bis 0,5 Gew.-% Mangan.

Das erfindungsgemäße Anschlusselement enthält bevorzugt Kovar (FeCoNi).

Kovar ist eine Eisen-Nickel-Kobalt Legierung, die Wärmeausdehnungskoeffizienten von üblicherweise etwa 5 × 10⁻⁶/°C aufweist. Der Wärmeausdehnungskoeffizient ist damit geringer als der Koeffizient typischer Metalle. Die Zusammensetzung enthält beispielsweise 54 Gew.-% Eisen, 29 Gew.-% Nickel und 17 Gew.-% Kobalt. Im Bereich der Mikroelektronik und Mikrosystemtechnik wird deshalb Kovar als Gehäusewerkstoff oder als Submount eingesetzt. Submounts liegen nach dem Sandwichprinzip zwischen dem eigentlichen Trägermaterial und dem Material mit meistens deutlich größerem Ausdehnungskoeffizienten. Kovar dient somit als ausgleichendes Element, welches die durch die unterschiedlichen Wärmeausdehnungskoeffizienten der anderen Materialien verursachten thermo-mechanischen Spannungen aufnimmt und verringert. In gleicher Weise dient Kovar für Metall-Glas-Durchführungen von elektronischen Bauelementen und Materialübergängen in Vakuumkammern.

Das erfindungsgemäße Anschlusselement enthält bevorzugt durch Glühen thermisch nachbehandelte Eisen-Nickel- und / oder Eisen-Nickel-Kobalt-Legierungen.

In einer weiteren vorteilhaften Ausgestaltung der Erfindung ist die Differenz zwischen dem ersten und dem zweiten Ausdehnungskoeffizienten ebenfalls < 5 × 10⁻⁶/°C. Der zweite thermische Ausdehnungskoeffizient ist dabei bevorzugt von 9 × 10⁻⁶/°C bis 13 × 10⁻⁶/°C, besonders bevorzugt von 10 × 10⁻⁶/°C bis 11,5 × 10⁻⁶/°C in einem Temperaturbereich von 0 °C bis 300 °C.

Das erfindungsgemäße Anschlusselement enthält bevorzugt zumindest 50 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän und / oder 0 Gew.-% bis 1 Gew.-% Titan. Das Anschlusselement kann zusätzlich Beimengungen weiterer Elemente enthalten, darunter Vanadium, Aluminium, Niob und Stickstoff.

Das erfindungsgemäße Anschlusselement kann auch zumindest 66,5 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän, 0 Gew.-% bis 2 Gew.-% Niob und / oder 0 Gew.-% bis 1 Gew.-% Titan enthalten. Das erfindungsgemäße Anschlusselement enthält bevorzugt zumindest 65 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1 Gew.-% Molybdän und / oder 0 Gew.-% bis 1 Gew.-% Titan.

Das erfindungsgemäße Anschlusselement kann auch zumindest 73 Gew.-% bis 89,5 Gew.-% Eisen, 10,5 Gew.-% bis 20 Gew.-% Chrom, 0 Gew.-% bis 0,5 Gew.-% Kohlenstoff, 0 Gew.-% bis 2,5 Gew.-% Nickel, 0 Gew.-% bis 1 Gew.-% Mangan, 0 Gew.-% bis 1 Gew.-% Molybdän, 0 Gew.-% bis 1 Gew.-% Niob und / oder 0 Gew.-% bis 1 Gew.-% Titan enthalten.

Das erfindungsgemäße Anschlusselement enthält bevorzugt zumindest 75 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan und / oder 0 Gew.-% bis 1 Gew.-% Titan.

Das erfindungsgemäße Anschlusselement kann auch zumindest 78,5 Gew.-% bis 84 Gew.-% Eisen, 16 Gew.-% bis 18,5 Gew.-% Chrom, 0 Gew.-% bis 0,1 Gew.-% Kohlenstoff, 0 Gew.-% bis 1 Gew.-% Mangan, 0 Gew.-% bis 1 Gew.-% Niob und / oder 0 Gew.-% bis 1 Gew.-% Titan enthalten.

Das erfindungsgemäße Anschlusselement enthält bevorzugt einen chromhaltigen Stahl mit einem Anteil an Chrom von größer oder gleich 10,5 Gew.-% und einem thermischen Ausdehnungskoeffizienten von 9 × 10⁻⁶/°C bis 13 × 10⁻⁶/°C. Weitere Legierungsbestandteile wie Molybdän, Mangan oder Niob führen zu einer verbesserten Korrosionsbeständigkeit oder veränderten mechanischen Eigenschaften, wie Zugfestigkeit oder Kaltumformbarkeit.

Der Vorteil von Anschlusselementen aus chromhaltigem Stahl gegenüber Anschlusselementen nach dem Stand der Technik aus Titan liegt in der besseren Lötbarkeit. Sie ergibt sich aus der höheren Wärmeleitfähigkeit von 25 W/mK bis 30 W/mK im Vergleich zur Wärmeleitfähigkeit des Titans von 22 W/mK. Die höhere Wärmeleitfähigkeit führt zu einer gleichmäßigeren Erwärmung des Anschlusselements während des Lötvorgangs, wodurch die punktuelle Ausbildung besonders heißer Stellen ("hot spots") vermieden wird. Diese Stellen sind Ausgangspunkte für spätere Beschädigungen der Scheibe. Es ergibt sich eine verbesserte Haftung des Anschlusselements an der Scheibe. Chromhaltiger Stahl ist zudem gut schweißbar. Dadurch ist eine bessere Verbindung des Anschlusselements mit der Bordelektrik über ein elektrisch leitfähiges Material, beispielsweise Kupfer, durch Verschweißen möglich. Aufgrund der besseren Kaltumformbarkeit kann das Anschlusselement auch besser mit dem elektrisch leitfähigen Material vercrimpt werden. Chromhaltiger Stahl ist zudem besser verfügbar.

Die erfindungsgemäße elektrisch leitfähige Struktur weist bevorzugt eine Schichtdicke von 5 µm bis 40 µm, besonders bevorzugt von 5 µm bis 20 µm, ganz besonders bevorzugt von 8 µm bis 15 µm und insbesondere von 10 µm bis 12 µm auf. Die erfindungsgemäße elektrisch leitfähige Struktur enthält bevorzugt Silber, besonders bevorzugt Silberpartikel und Glasfritten.

Die erfindungsgemäße Schichtdicke des Lots ist bevorzugt < 3.0 × 10⁻⁴ m.

Die Lotmasse ist bevorzugt bleifrei, enthält also kein Blei. Das ist besonders vorteilhaft im Hinblick auf die Umweltverträglichkeit der erfindungsgemäßen Scheibe mit elektrischem Anschlusselement. Bleifrei Lotmassen weisen typischerweise eine geringere Duktilität auf als bleihaltige Lotmassen, so dass mechanische Spannungen zwischen Anschlusselement und Scheibe weniger gut kompensiert werden können. Es hat sich aber gezeigt, dass kritische mechanische Spannungen durch das erfindungsgemäße Anschlusselement vermieden werden können. Die erfindungsgemäße Lotmasse enthält bevorzugt Zinn und Wismut, Indium, Zink, Kupfer, Silber oder Zusammensetzungen davon. Der Anteil an Zinn in der erfindungsgemäßen Lotzusammensetzung beträgt von 3 Gew.-% bis 99,5 Gew.-%, bevorzugt von 10 Gew.-% bis 95,5 Gew.-%, besonders bevorzugt von 15 Gew.-% bis 60 Gew.-%. Der Anteil an Wismut, Indium, Zink, Kupfer, Silber oder Zusammensetzungen davon beträgt in der erfindungsgemäßen Lotzusammensetzung von 0,5 Gew.-% bis 97 Gew.-%, bevorzugt 10 Gew.-% bis 67 Gew.-%, wobei der Anteil an Wismut, Indium, Zink, Kupfer oder Silber 0 Gew.-% betragen kann. Die erfindungsgemäße Lotzusammensetzung kann Nickel, Germanium, Aluminium oder Phosphor mit einem Anteil von 0 Gew.-% bis 5 Gew.-% enthalten. Die erfindungsgemäße Lotzusammensetzung enthält ganz besonders bevorzugt Bi40Sn57Ag3, Sn40Bi57Ag3, Bi59Sn40Ag1, Bi57Sn42Ag1, In97Ag3, Sn95,5Ag3,8Cu0,7, Bi67In33, Bi33In50Sn17, Sn77,2In20Ag2,8, Sn95Ag4Cu1, Sn99Cu1, Sn96,5Ag3,5 oder Gemische davon.

Das erfindungsgemäße Anschlusselement ist bevorzugt mit Nickel, Zinn, Kupfer und / oder Silber beschichtet. Das erfindungsgemäße Anschlusselement ist besonders bevorzugt mit einer haftvermittelnden Schicht, bevorzugt aus Nickel und / oder Kupfer, und zusätzlich mit einer lötbaren Schicht, bevorzugt aus Silber, versehen. Das erfindungsgemäße Anschlusselement ist ganz besonders bevorzugt mit 0,1 µm bis 0,3 µm Nickel und / oder 3 µm bis 20 µm Silber beschichtet. Das Anschlusselement kann vernickelt, verzinnt, verkupfert und / oder versilbert werden. Nickel und Silber verbessern die Stromtragfähigkeit und Korrosionsstabilität des Anschlusselements und die Benetzung mit der Lotmasse.

Der Winkel zwischen der Oberfläche des Substrats und jeder der Tangentialebenen der zum Substrat hingewandten Flächen der Übergangsbereiche des Anschlusselements beträgt bevorzugt zwischen 1° und 85°, besonders bevorzugt zwischen 2° und 75°, ganz besonders bevorzugt zwischen 3° und 60°, insbesondere zwischen 5° und 50°. Der Winkel zwischen der Oberfläche des Substrats und der Tangentialebenen darf nicht im gesamten Übergangsbereich gleich 0° sein, da in diesem Fall kein Zwischenraum zwischen Übergangsbereich und elektrisch leitfähiger Struktur zur Aufnahme überschüssiger Lotmasse gebildet wird. Das erfindungsgemäße Anschlusselement ist zudem so ausgeformt, dass die Tangentialebenen in die dem unmittelbar angrenzenden Fußbereich abgewandte Richtung geneigt sind.

In einer bevorzugten Ausgestaltung der Erfindung sind die Übergangsbereiche und der Brückenbereich des Anschlusselements abschnittsweise plan ausgeformt. Plan bedeutet, dass die Unterseite des Anschlusselements eine Ebene bildet.

Besonders bevorzugt sind die Übergangsbereiche plan ausgeformt und der Brückenbereich ist plan oder abschnittsweise plan ausformt. Jede Tangentialebene an eine zum Substrat hingewandte Fläche eines Übergangsbereichs entspricht dabei der ebenen Unterseite des Übergangsbereichs. Die Oberfläche des Substrats und die zum Substrat hingewandte Fläche des ersten Übergangsbereichs schließen einen Winkel α₁ ein. Die Oberfläche des Substrats und die zum Substrat hingewandte Fläche des zweiten Übergangsbereichs schließen einen Winkel α₂ ein. In einer besonders bevorzugten Ausgestaltung der Erfindung ist der Winkel α₁ gleich dem Winkel α₂. Die Winkel α₁ und α₂ sind ungleich 0°.

Die Übergangsbereiche können auch abschnittsweise plan ausgeformt sein. Die Winkel α₁ und α₂ sind dabei in den an die Fußbereiche grenzenden, planen Abschnitten der Übergangsbereiche zu bestimmen. Die Winkel α₁ und α₂ sind ungleich 0°. Die zum Substrat hingewandten Flächen der übrigen planen Abschnitte der Übergangsbereiche dürfen mit der Oberfläche des Substrats einen Winkel gleich 0° einschließen.

In einer weiteren vorteilhaften Ausgestaltung der Erfindung sind die beiden Übergangsbereiche und / oder der Brückenbereich gekrümmt. Die beiden Übergangsbereiche und der Brückenbereich haben bevorzugt die gleiche Krümmungsrichtung und bilden bevorzugt gemeinsam das Profil eines ovalen Bogens, besonders bevorzugt das Profil eines Ellipsenbogens und ganz besonders bevorzugt das Profil eines Kreisbogens. Der Krümmungsradius des Kreisbogens beträgt beispielsweise bevorzugt von 5 mm bis 15 mm bei einer Länge des Anschlusselements von 24 mm. Haben die beiden Übergangsbereiche und der Brückenbereich die gleiche Krümmungsrichtung, so sind die Verbindungen zwischen den Kontaktflächen und den zum Substrat hingewandten Flächen der Übergangsbereiche als Kanten ausgeformt. Die Krümmungsrichtungen der Übergangsbereiche und / oder des Brückenbereichs können sich auch ändern.

In einer weiteren vorteilhaften Ausgestaltung der Erfindung sind die beiden Übergangsbereiche plan ausgeformt und der Brückenbereich ist gewinkelt. Der Brückenbereich besteht dabei aus zwei planen Teilbereichen, die miteinander einen Winkel γ einschließen. Die Oberfläche des Substrats und die zum Substrat hingewandte Fläche des ersten Übergangsbereichs schließen einen Winkel β₁ ein. Die Oberfläche des Substrats und die zum Substrat hingewandte Fläche des zweiten Übergangsbereichs schließen einen Winkel β₂ ein. Der Winkel γ beträgt 180° - β₁ - β₂. In einer besonders bevorzugten Ausgestaltung der Erfindung sind die Winkel β₁ und β₂ gleich.

Die Eisen-Nickel-Legierung, die Eisen-Nickel-Kobalt-Legierung oder die Eisen-Chrom-Legierung können auch als Ausgleichsplatte auf ein Anschlusselement aus beispielsweise Stahl, Aluminium, Titan, Kupfer angeschweißt, gecrimpt oder geklebt werden. Als Bimetall kann ein günstiges Ausdehnungsverhalten des Anschlusselementes relativ zur Glasausdehnung erzielt werden. Die Ausgleichsplatte ist bevorzugt hutförmig.

Das elektrische Anschlusselement enthält auf der zur Lotmasse ausgerichteten Fläche eine Beschichtung, die Kupfer, Zink, Zinn, Silber, Gold oder Legierungen oder Schichten davon, bevorzugt Silber enthält. Dadurch wurde eine Ausbreitung der Lotmasse über die Beschichtung hinweg verhindert und die Austrittsbreite begrenzt.

Die Anschlusselemente sind in der Draufsicht beispielsweise bevorzugt 1 mm bis 50 mm lang und breit und besonders bevorzugt 2 mm bis 30 mm lang und breit und ganz besonders bevorzugt 2 mm bis 5 mm breit und 12 mm bis 24 mm lang.

Die Kontaktflächen an den Unterseiten der Fußbereiche sind beispielsweise bevorzugt 1 mm bis 15 mm lang und breit und besonders bevorzugt 2 mm bis 8 mm lang und breit und ganz besonders bevorzugt 2 mm bis 5 mm breit und 2 mm bis 5 mm lang.

Die Form des elektrischen Anschlusselementes kann Lotdepots im Zwischenraum von Anschlusselement und elektrisch leitfähiger Struktur ausbilden. Die Lotdepots und Benetzungseigenschaften des Lotes am Anschlusselement verhindern den Austritt der Lotmasse aus dem Zwischenraum. Lotdepots können rechtwinklig, verrundet oder polygonal ausgestaltet sein.

Die Verteilung der Lotwärme und damit die Verteilung der Lotmasse im Lötvorgang kann durch die Form des Anschlusselementes definiert werden. Lotmasse fließt zum wärmsten Punkt. Beispielsweise kann die das Anschlusselement eine Einfach- oder Doppelhutform aufweisen, um die Wärme während des Lötvorgangs vorteilhaft im Anschlusselement zu verteilen.

In einer vorteilhaften Ausgestaltung der Erfindung ist an jeder der Kontaktflächen mindestens ein, bevorzugt mindestens zwei Abstandshalter angeordnet. Die Abstandshalter enthalten bevorzugt die gleiche Legierung wie das Anschlusselement. Jeder Abstandshalter ist beispielsweise als Würfel, als Pyramide, als Segment eines Rotationsellipsoids oder als Kugelsegment ausgeformt. Die Abstandshalter haben bevorzugt eine Breite von 0,5 × 10⁻⁴ m bis 10 × 10⁻⁴ m und eine Höhe von 0,5 × 10⁻⁴ m bis 5 × 10⁻⁴ m, besonders bevorzugt von 1x 10⁻⁴ m bis 3 × 10⁻⁴ m. Durch die Abstandshalter wird die Ausbildung einer gleichmäßigen Lotmasseschicht begünstigt. Das ist besonders vorteilhaft in Hinblick auf die Haftung des Anschlusselements. Die Abstandshalter sind in einer bevorzugten Ausgestaltung einstückig mit dem Anschlusselement ausgebildet.

Das Einbringen der Energie beim elektrischen Verbinden von elektrischem Anschlusselement und elektrisch leitfähiger Struktur erfolgt bevorzugt mit Stempel, Thermoden, Kolbenlöten, bevorzugt Laserlöten, Heißluftlöten, Induktionslöten, Widerstandslöten und/oder mit Ultraschall.

Die Aufgabe der Erfindung wird weiter durch ein Verfahren zur Herstellung einer Scheibe mit mindestens einem Anschlusselement gelöst, wobei
a) Lotmasse auf den Kontaktflächen des Anschlusselements als Plättchen mit festgelegter Schichtdicke, Volumen und Form angeordnet und aufgebracht wird,
b) eine elektrisch leitfähige Struktur auf einem Bereich eines Substrats aufgebracht wird,
c) das Anschlusselement mit der Lotmasse auf der elektrisch leitfähigen Struktur angeordnet wird und
d) das Anschlusselement mit der elektrisch leitfähigen Struktur verlötet wird.

Die Lotmasse wird bevorzugt vorher auf die Anschlusselemente appliziert, bevorzugt als Plättchen mit festgelegter Schichtdicke, Volumen, Form und Anordnung auf dem Anschlusselement.

Das Anschlusselement kann beispielsweise mit einem Blech, einer Litze oder einem Geflecht aus beispielsweise Kupfer verschweißt oder gecrimpt werden und mit der Bordelektrik verbunden werden.

Das erfindungsgemäße Anschlusselement ist bevorzugt einstückig ausgebildet, kann aber auch aus zwei oder mehreren miteinander verbundenen, beispielsweise verschweißten Teilelementen bestehen.

Das Anschlusselement wird bevorzugt in Heizscheiben oder in Scheiben mit Antennen in Gebäuden, insbesondere in Automobilen, Eisenbahnen, Flugzeugen oder Seefahrzeugen benutzt. Das Anschlusselement dient dazu, die leitenden Strukturen der Scheibe mit elektrischen Systemen zu verbinden, welche außerhalb der Scheibe angeordnet sind. Die elektrischen Systeme sind Verstärker, Steuereinheiten oder Spannungsquellen.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
Fig. 1 eine perspektivische Darstellung einer ersten Ausgestaltung der erfindungsgemäßen Scheibe,
Fig. 1a einen Schnitt C-C' durch die Scheibe gemäß der Figur 1,
Fig. 2 einen Schnitt A-A' durch die Scheibe gemäß der Figur 1,
Fig. 3 einen Schnitt A-A' durch eine alternative erfindungsgemäße Scheibe,
Fig. 4 einen Schnitt A-A' durch eine weitere alternative erfindungsgemäße Scheibe,
Fig. 5 einen Schnitt A-A' durch eine weitere alternative erfindungsgemäße Scheibe,
Fig. 6 eine perspektivische Darstellung einer alternativen Ausgestaltung der erfindungsgemäßen Scheibe,
Fig. 7 einen Schnitt B-B' durch die Scheibe gemäß der Figur 6,
Fig. 8 einen Schnitt C-C' durch eine alternative erfindungsgemäße Scheibe,
Fig. 9 einen Schnitt C-C' durch eine weitere alternative erfindungsgemäße Scheibe,
Fig. 10 einen Schnitt C-C' durch eine weitere alternative erfindungsgemäße Scheibe,
Fig. 11 einen Schnitt C-C' durch eine weitere alternative erfindungsgemäße Scheibe,
Fig. 12 einen Schnitt C-C' durch eine weitere alternative erfindungsgemäße Scheibe,
Fig. 12a einen Schnitt C-C' durch eine weitere alternative erfindungsgemäße Scheibe,
Fig. 13 eine Draufsicht auf eine alternative Ausgestaltung des Anschlusselements,
Fig. 14 eine perspektivische Darstellung einer alternativen Ausgestaltung des Anschlusselements, und
Fig. 15 ein detailliertes Flussdiagramm des erfindungsgemäßen Verfahrens.

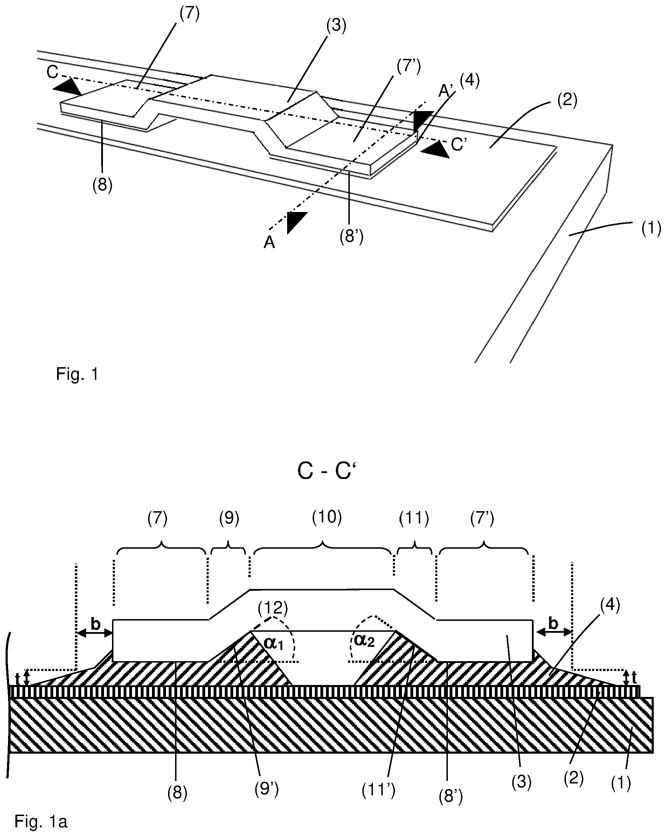

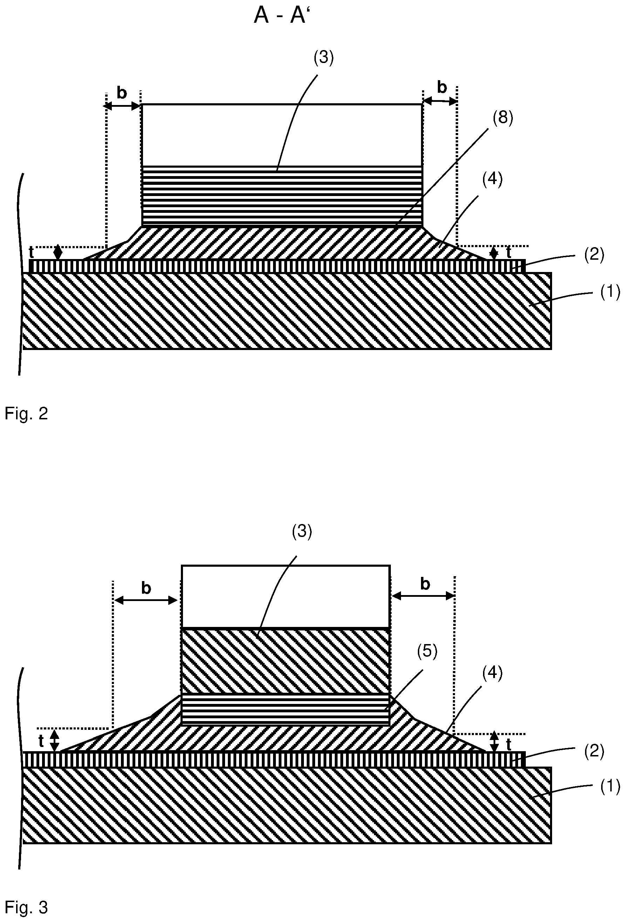

Fig.1, Fig. 1a und Fig. 2 zeigen je ein Detail einer erfindungsgemäßen beheizbaren Scheibe 1 im Bereich des elektrischen Anschlusselementes 3. Die Scheibe 1 ist ein 3 mm dickes thermisch vorgespanntes Einscheibensicherheitsglas aus Natron-Kalk-Glas. Die Scheibe 1 weist eine Breite von 150 cm und eine Höhe von 80 cm auf. Auf der Scheibe 1 ist eine elektrisch leitfähige Struktur 2 in Form einer Heizleiterstruktur 2 aufgedruckt. Die elektrisch leitfähige Struktur 2 enthält Silberpartikel und Glasfritten. Im Randbereich der Scheibe 1 ist die elektrisch leitfähige Struktur 2 auf eine Breite von 10 mm verbreitert und bildet eine Kontaktfläche für das elektrische Anschlusselement 3. Im Randbereich der Scheibe 1 befindet sich weiter ein nicht dargestellter Abdecksiebdruck. Im Bereich der Kontaktflächen 8 und 8' und der zum Substrat 1 hingewandten Flächen 9' und 11' der Übergangsbereiche 9 und 11 bewirkt die Lotmasse 4 eine dauerhafte elektrische und mechanische Verbindung zwischen dem Anschlusselement 3 und der elektrisch leitfähigen Struktur 2. Die Lotmasse 4 enthält 57 Gew.-% Wismut, 40 Gew.-% Zinn und 3 Gew.-% Silber. Die Lotmasse 4 ist durch ein vorgegebenes Volumen und Form vollständig zwischen dem elektrischen Anschlusselement 3 und der elektrisch leitfähigen Struktur 2 angeordnet. Die Lotmasse 4 hat eine Dicke von 250 µm. Das elektrische Anschlusselement 3 besteht aus Stahl der Werkstoff-Nummer 1.4509 nach EN 10 088-2 (ThyssenKrupp Nirosta^{®} 4509) mit einem thermischen Ausdehnungskoeffizienten von 10,0 × 10⁻⁶/°C. Das elektrische Anschlusselement 3 hat eine Breite von 4 mm und eine Länge von 24 mm. Die Übergangsbereiche 9 und 11 und der Brückenbereich 10 sind plan ausgeformt. Die Oberfläche des Substrats 1 und die zum Substrat 1 hingewandte Fläche 9' des Übergangsbereichs 9 schließen einen Winkel α₁ = 40° ein. Die Oberfläche des Substrats und die zum Substrat 1 hingewandte Fläche 11' des Übergangsbereichs 11 schließen einen Winkel α₂ = 40°. Der Brückenbereich 10 ist parallel zur Oberfläche des Substrats 1 angeordnet.

Stahl der Werkstoff-Nummer 1.4509 nach EN 10 088-2 ist gut kaltumformbar und gut schweißbar mit allen Verfahren außer Gasschweißung. Der Stahl wird für den Bau von Schalldämpfer- und Abgasentgiftungsanlagen eingesetzt und ist dafür aufgrund der Zunderbeständigkeit bis über 950 °C und Korrosionsbeständigkeit gegen die im Abgassystem auftretenden Beanspruchungen besonders geeignet.

Fig. 3 zeigt in Fortführung des Ausführungsbeispiels der Figuren 1 und 2 eine alternative Ausgestaltung des erfindungsgemäßen Anschlusselementes 3. Das elektrische Anschlusselement 3 ist auf der zur Lotmasse 4 hin ausgerichteten Fläche mit einer silberhaltigen Beschichtung 5 versehen. Dadurch wird eine Ausbreitung der Lotmasse über die Beschichtung 5 hinweg verhindert und die Austrittsbreite b begrenzt. In einer weiteren Ausgestaltung kann sich zwischen Anschlusselement 3 und silberhaltiger Schicht 5 eine haftvermittelnde Schicht, beispielsweise aus Nickel und / oder Kupfer, befinden. Die Austrittsbreite b der Lotmasse 4 ist unterhalb von 1 mm. Aufgrund der Anordnung der Lotmasse 4 werden keine kritischen mechanischen Spannungen in der Scheibe 1 beobachtet. Die Verbindung der Scheibe 1 mit dem elektrischen Anschlusselement 3 ist über die elektrisch leitfähige Struktur 2 dauerhaft stabil.

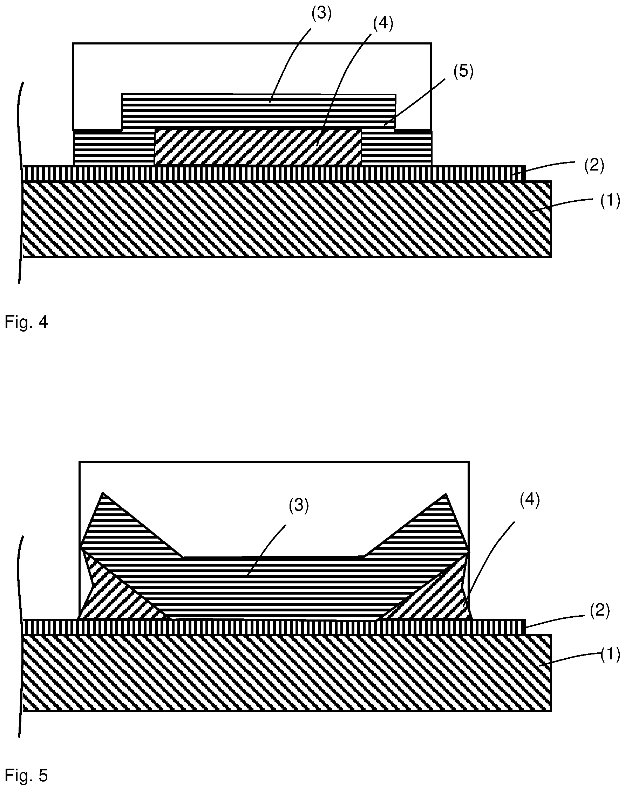

Fig. 4 zeigt in Fortführung des Ausführungsbeispiels der Figuren 1 und 2 eine weitere alternative Ausgestaltung des erfindungsgemäßen Anschlusselementes 3. Das elektrische Anschlusselement 3 enthält auf der zur Lotmasse 4 hin ausgerichteten Fläche eine Aussparung mit einer Tiefe von 250 µm, die ein Lotdepot für die Lotmasse 4 bildet. Ein Austritt der Lotmasse 4 aus dem Zwischenraum kann vollständig verhindert werden. Die thermischen Spannungen in der Scheibe 1 sind unkritisch und es wird eine dauerhafte elektrische und mechanische Verbindung zwischen den Anschlusselement 3 und der Scheibe 1 über die elektrisch leitfähige Struktur 2 bereitgestellt.

Fig. 5 zeigt in Fortführung des Ausführungsbeispiels der Figuren 1 und 2 eine weitere alternative Ausgestaltung des erfindungsgemäßen Anschlusselementes 3. Das elektrische Anschlusselement 3 ist an den Randbereichen aufgebogen. Die Höhe der Aufbiegung der Randbereiche von der Glasscheibe 1 beträgt maximal 400 µm. Dadurch wird ein Raum für die Lotmasse 4 gebildet. Die vorgegebene Lotmasse 4 bildet zwischen dem elektrischen Anschlusselement 3 und der elektrisch leitfähigen Struktur 2 einen konkaven Meniskus. Ein Austritt von Lotmasse 4 aus dem Zwischenraum kann vollständig verhindert werden. Die Austrittsbreite b ist in etwa 0, größtenteils aufgrund des gebildeten Meniskus unterhalb von null. Die thermischen Spannungen in der Scheibe 1 sind unkritisch und es wird eine dauerhafte elektrische und mechanische Verbindung zwischen dem Anschlusselement 3 und der Scheibe 1 über die elektrisch leitfähige Struktur 2 bereitgestellt.

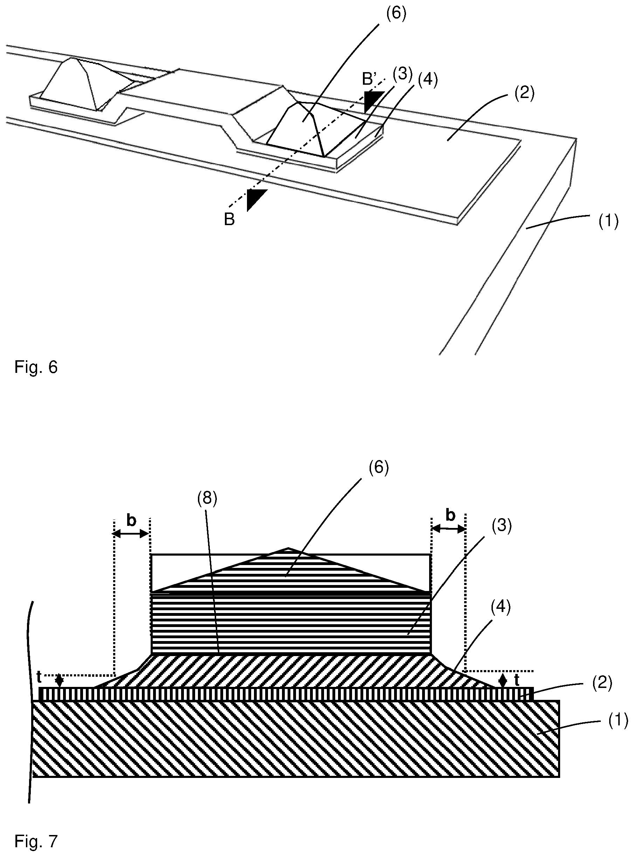

Fig. 6 und Fig. 7 zeigen je ein Detail einer weiteren Ausgestaltung der erfindungsgemäßen Scheibe 1 mit Anschlusselement 3. Das Anschlusselement 3 enthält eine eisenhaltige Legierung mit einem thermischen Ausdehnungskoeffizienten von 8 × 10⁻⁶/°C. Die Materialdicke beträgt 2 mm. Im Bereich der Kontaktflächen 8 und 8' des Anschlusselementes 3 sind hutförmige Ausgleichskörper 6 mit chromhaltigem Stahl der Werkstoff-Nummer 1.4509 nach EN 10 088-2 (ThyssenKrupp Nirosta^{®} 4509) aufgebracht. Die maximale Schichtdicke der hutförmigen Ausgleichskörper 6 beträgt 4 mm. Durch die Ausgleichskörper können die thermischen Ausdehnungskoeffizienten des Anschlusselementes 3 den Erfordernissen der Scheibe 1 und der Lotmasse 4 angepasst werden. Die hutförmigen Ausgleichskörper 6 führen zu einem verbesserten Wärmefluss während der Herstellung der Lotverbindung 4. Die Erwärmung erfolgt vor allem im Zentrum der Kontaktflächen 8 und 8'. Die Austrittsbreite b der Lotmasse 4 kann weiter reduziert werden. Aufgrund der geringen Austrittsbreite b von < 1 mm und des angepassten Ausdehnungskoeffizienten können die thermischen Spannungen in der Scheibe 1 weiter reduziert werden. Die thermischen Spannungen in der Scheibe 1 sind unkritisch und es wird eine dauerhafte elektrische und mechanische Verbindung zwischen dem Anschlusselement 3 und der Scheibe 1 über die elektrisch leitfähige Struktur 2 bereitgestellt.

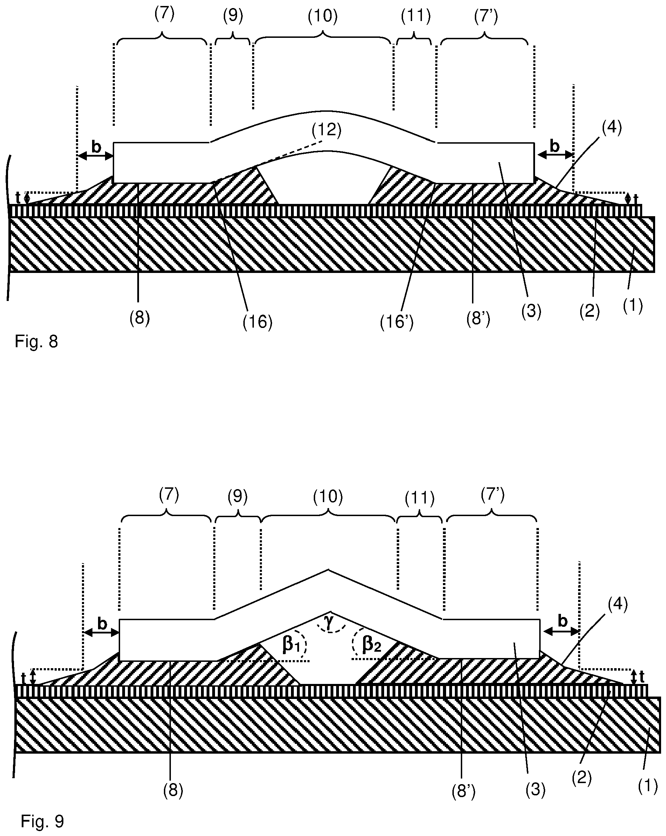

Fig. 8 zeigt in Fortführung des Ausführungsbeispiels der Figuren 1 und 1a eine alternative Ausgestaltung des erfindungsgemäßen Anschlusselementes 3. Die beiden Übergangsbereiche 9 und 11 und der Brückenbereich 10 sind gekrümmt und haben die gleiche Krümmungsrichtung. Sie bilden gemeinsam das Profil eines Kreisbogens mit einem Krümmungsradius von 12 mm. Die Verbindungen 16 und 16' zwischen den Kontaktflächen 8 und 8' und den zum Substrat hingewandten Flächen 9' und 11' der gekrümmten Übergangsbereiche 9 und 11 sind als Kanten ausgeformt. Die thermischen Spannungen in der Scheibe 1 sind unkritisch und es wird eine dauerhafte elektrische und mechanische Verbindung zwischen den Anschlusselement 3 und der Scheibe 1 über die elektrisch leitfähige Struktur 2 bereitgestellt.

Fig. 9 zeigt in Fortführung des Ausführungsbeispiels der Figuren 1 und 1a eine weitere alternative Ausgestaltung des erfindungsgemäßen Anschlusselementes 3. Die beiden Übergangsbereiche sind plan ausgeformt, der Brückenbereich ist gewinkelt ausgeformt. Die Oberfläche des Substrats 1 und die zum Substrat 1 hingewandte Fläche 9' des Übergangsbereichs 9 schließen einen Winkel β₁ = 20° ein. Die Oberfläche des Substrats 1 und die zum Substrat 1 hingewandte Fläche 11' des Übergangsbereichs 11 schließen einen Winkel β₂ = 20° ein. Der Winkel γ des Brückenbereichs beträgt 140°. Die thermischen Spannungen in der Scheibe 1 sind unkritisch und es wird eine dauerhafte elektrische und mechanische Verbindung zwischen den Anschlusselement 3 und der Scheibe 1 über die elektrisch leitfähige Struktur 2 bereitgestellt.

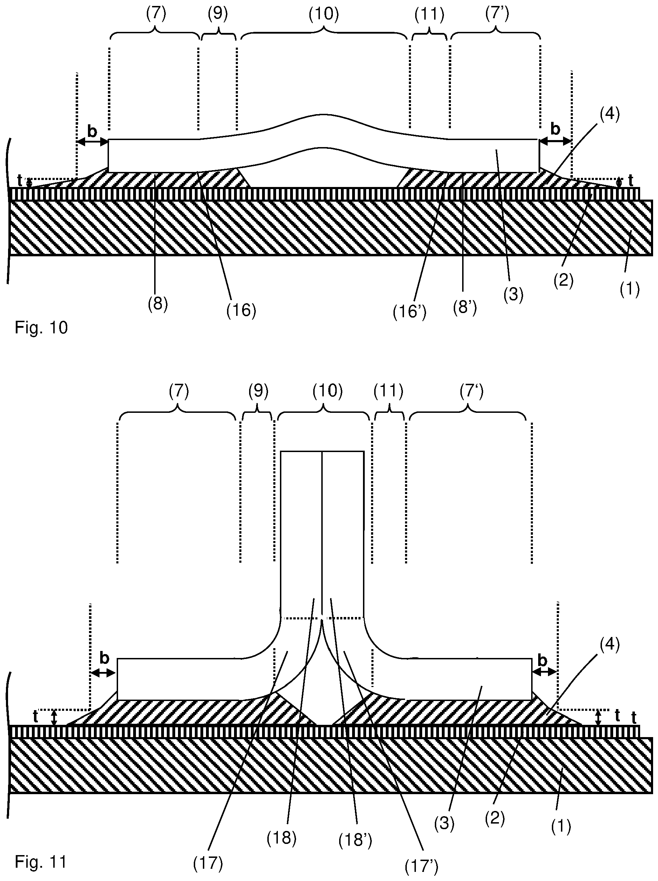

Fig. 10 zeigt in Fortführung des Ausführungsbeispiels der Figuren 1 und 1a eine weitere alternative Ausgestaltung des erfindungsgemäßen Anschlusselementes 3. Die beiden Übergangsbereiche 9 und 11 und der Brückenbereich 10 sind gekrümmt. Die Struktur aus den Übergangsbereichen 9 und 11 und dem Brückenbereich 10 ändert zweimal ihre Krümmungsrichtung. Angrenzend an die Fußbereiche 7 und 7' weist die Krümmungsrichtung der Übergangsbereiche 9 und 11 vom Substrat 1 weg. Dadurch gibt es an den Verbindungen 16 und 16' zwischen den Kontaktflächen 8 und 8' und den zum Substrat hingewandten Flächen 9' und 11' der gekrümmten Übergangsbereiche 9 und 11 keine Kanten. Die Unterseite des Anschlusselements weist einen kontinuierlichen Verlauf auf. Die thermischen Spannungen in der Scheibe 1 sind unkritisch und es wird eine dauerhafte elektrische und mechanische Verbindung zwischen den Anschlusselement 3 und der Scheibe 1 über die elektrisch leitfähige Struktur 2 bereitgestellt.

Fig. 11 zeigt eine weitere alternative Ausgestaltung des erfindungsgemäßen Anschlusselementes 3. Die beiden Übergangsbereiche 9 und 11 sind gekrümmt, wobei die Krümmungsrichtung vom Substrat 1 weg weist. Der Brückenbereich 10 besteht aus zwei Teilelementen. Die Teilelemente haben jeweils einen gekrümmten Teilbereich 17 und 17' und einen planen Teilbereich 18 und 18'. Der Brückenbereich 10 ist durch den Teilbereich 17 mit dem Übergangsbereich 9 und durch den Teilbereich 17' mit dem Übergangsbereich 11 verbunden. Die gekrümmten Teilbereiche 17 und 17' haben die gleiche Krümmungsrichtung wie der angrenzende Übergangsbereich. Die planen Teilbereiche 18 und 18' sind senkrecht zur Oberfläche des Substrats angeordnet und befinden sich in direktem Kontakt miteinander.

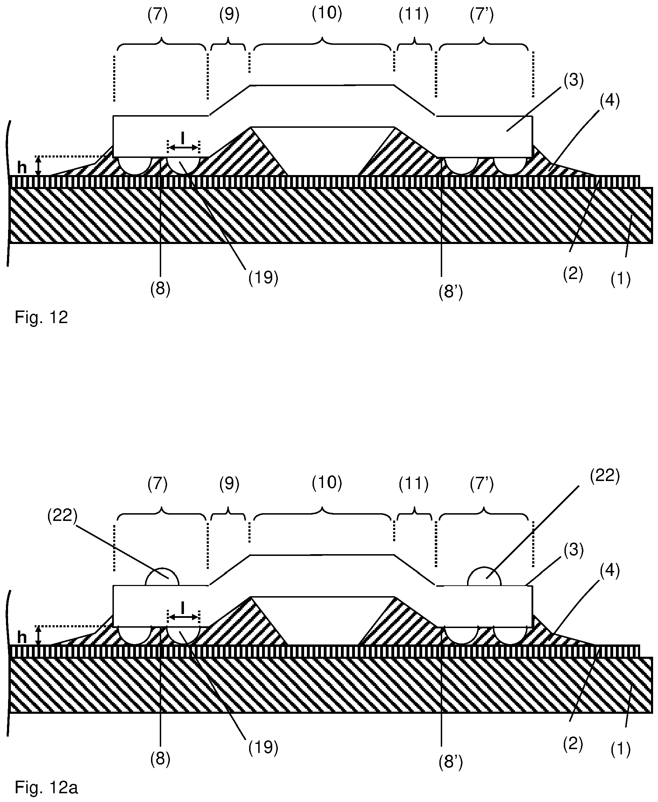

Fig. 12 zeigt in Fortführung des Ausführungsbeispiels der Figuren 1 und 1a eine weitere alternative Ausgestaltung des erfindungsgemäßen Anschlusselementes 3. Die Fußbereiche 7 und 7', die Übergangsbereiche 9 und 11 und der Brückenbereich 10 sind gemäß der Figur 1a ausgeformt. Die Kontaktflächen 8 und 8' haben eine Breite von 4 mm und eine Länge von 4 mm. An den Kontaktflächen 8 und 8' sind Abstandshalter 19 angebracht. Die Abstandshalter sind als Halbkugeln ausgeformt und haben eine Höhe h von 2,5 × 10⁻⁴ m und eine Breite I von 5 × 10⁻⁴ m.

Die Abstandshalter 19 können in alternativen Ausgestaltungen auch beispielsweise als Würfel, als Pyramide oder als Segment eines Rotationsellipsoids ausgestaltet sein und bevorzugt eine Breite von 0,5 × 10⁻⁴ m bis 10 × 10⁻⁴ m und eine Höhe von 0,5 × 10⁻⁴ m bis 5 × 10⁻⁴ m, besonders bevorzugt von 1× 10⁻⁴ m bis 3 × 10⁻⁴ m aufweisen. Durch die Abstandshalter 19 wird die Ausbildung einer gleichmäßigen Schicht der Lotmasse 4 begünstigt. Das ist besonders vorteilhaft in Hinblick auf die Haftung des Anschlusselements 3.

Fig. 12a zeigt in Fortführung des Ausführungsbeispiels der Figur 12 eine weitere alternative Ausgestaltung des erfindungsgemäßen Anschlusselementes 3. An jeder vom Substrat 1 angewandten Flächen der Fußbereiche 7, 7' ist ein Kontakterhebung 22 angeordnet. Die Kontakterhebungen 22 sind in der gezeigten Ausgestaltung als Halbkugeln ausgeformt und haben eine Höhe von 2,5 × 10⁻⁴ m und eine Breite von 5 × 10⁻⁴ m. Die Mittelpunkte der Kontakterhebungen 22 sind etwa in der geometrischen Mitte der vom Substrat 1 angewandten Flächen der Fußbereiche 7, 7' angeordnet. Die Kontakterhebungen 22 ermöglichen aufgrund ihrer konvexen Oberfläche ein vorteilhaft verbessertes Verlöten des Anschlusselements 3 mit der elektrisch leitfähigen Struktur 2. Zum Löten können Elektroden verwendet werden, deren Kontaktseite flach ausgeformt ist. Die Elektrodenfläche wird mit der Kontakterhebung 22 in Kontakt gebracht, wobei der Kontaktbereich zwischen Elektrodenfläche und Kontakterhebung 22 die Lötstelle bildet. Die Position der Lötstelle wird dabei bevorzugt durch den Punkt auf der konvexen Oberfläche der Kontakterhebung 22 bestimmt, der den größten lotrechten Abstand zur Oberfläche des Substrats 1 aufweist. Die Position der Lötstelle ist unabhängig von der Position der Lötelektrode auf dem Anschlusselement 3. Das ist besonders vorteilhaft im Hinblick auf eine reproduzierbare, gleichmäßige Wärmeverteilung während des Lötvorgangs.

Die Wärmeverteilung während des Lötvorgangs wird durch die Position, die Größe, die Anordnung und die Geometrie der Kontakterhebung 22 bestimmt. In alternativen Ausgestaltungen kann die Kontakterhebung 22 beispielsweise als Segment eines Rotationsellipsoids oder als Quader ausgeformt sein, wobei die vom Substrat abgewandte Fläche des Quaders konvex gekrümmt ausgeformt ist. Die Kontakterhebungen 22 haben bevorzugt eine Höhe von 0,1 mm bis 2 mm, besonders bevorzugt von 0,2 mm bis 1 mm. Die Länge und Breite der Kontakterhebungen 22 beträgt bevorzugt zwischen 0,1 und 5 mm, ganz besonders bevorzugt zwischen 0,4 mm und 3 mm.

Die Kontakterhebungen 22 und die Abstandshalter 19 können in einer vorteilhaften Ausgestaltung einstückig mit dem Anschlusselement 3 ausgebildet sein. Die Kontakterhebungen 22 und die Abstandshalter 19 können beispielsweise durch Umformen eines Anschlusselementes 3 mit im Ausgangszustand planer Oberfläche auf der Oberfläche ausgebildet werden, beispielsweise durch Prägen oder Tiefziehen. Dabei kann eine entsprechende Vertiefung auf der der Kontakterhebung 22 beziehungsweise dem Abstandshalter 19 gegenüberliegenden Oberfläche des Anschlusselements 3 erzeugt werden.

Durch die Kontakterhebungen 22 und die Abstandshalter 19 wird eine homogene, gleichmäßig dicke und gleichmäßig aufgeschmolzene Schicht der Lotmasse 4 erreicht. Dadurch können mechanische Spannungen zwischen Anschlusselement 3 und Substrat 1 verringert werden. Das ist insbesondere bei der Verwendung bleifreier Lotmassen besonders vorteilhaft, die aufgrund ihrer geringeren Duktilität im Vergleich zu bleihaltigen Lotmassen mechanische Spannungen weniger gut kompensieren können.

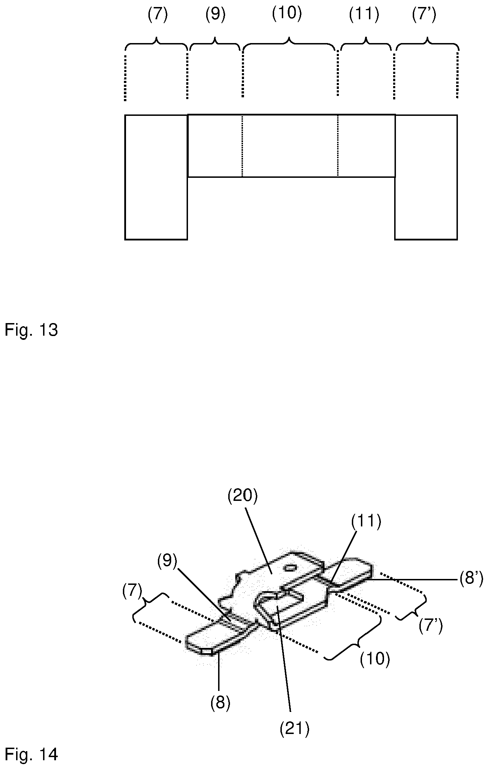

Fig. 13 zeigt eine Draufsicht auf eine alternative Ausgestaltung des erfindungsgemäßen Anschlusselements 3. Die Übergangsbereiche 9 und 11 und der Brückenbereich 10 sind gemäß der Figur 1a ausgeformt. Jeder Fußbereich 7 und 7' hat eine Breite von 8 mm und ist doppelt so breit wie die Übergangsbereiche 9 und 11 und der Brückenbereich 10. Es hat sich überraschend gezeigt, dass Fußbereiche 7,7', die breiter ausgestaltet sind als die Übergangsbereiche 9,11 und der Brückenbereich 10 zu einer Verringerung der mechanischen Spannungen in der Scheibe 1 führen. Die Breite der Fußbereiche 7,7' beträgt dabei bevorzugt von 150 % bis 300 % der Breite des Brückenbereichs 10.

Fig. 14 zeigt eine perspektivische Darstellung einer alternativen Ausgestaltung des erfindungsgemäßen Anschlusselements 3. Die Fußbereiche 7 und 7' weisen beispielsweise eine Länge von 7 mm und eine Breite von 5 mm auf. Der Brückenbereich 10 ist plan ausgestaltet und weist beispielsweise eine Länge von 12 mm und eine Breite von 10 mm auf. Der Brückenbereich 10 ist breiter als die Fußbereiche 7, 7' und weist eine herstellungsbedingte Aussparung 21 auf. Die Aussparung 21 verläuft bis zu der Kante des Brückenbereichs 10, an die sich der Fußbereich 7 über den Übergangsbereich 9 anschließt. Die Aussparung 21 entspricht in Form und Größe dem Abschnitt des Anschlusselementes 3 aus dem Fußbereich 7 und dem Übergangsbereich 9. Die Kontaktflächen 8 und 8' an den Unterseiten der Fußbereich 7 und 7' weisen eine rechteckige Form auf, wobei die beiden jeweils vom Brückenbereich 10 abgewandten Ecken abgefast sind. Durch die Abfasung werden zu kleine Winkel, insbesondere 90°-Winkel entlang der umlaufenden Seitenkanten der Kontaktflächen 8, 8' vermieden. Es hat sich gezeigt, dass dadurch mechanische Spannungen in der Scheibe verringert werden können.

Das Anschlusselement 3 enthält einen auf dem Brückenbereich 10 angeordneten Anschlussstecker 20. Der Anschlussstecker 20 ist an der an den Übergangsbereich 9 grenzenden Seitenkante des Brückenbereichs 10 mit dem Brückenbereich 10 verbunden. Der Anschlussstecker 20 ist als normgerechter Flachsteckverbinder ausgestaltet, auf welchen die Kupplung eines nicht dargestellten Verbindungskabels beispielsweise zur Bordelektrik aufgesteckt werden kann.

Der besondere Vorteil der Ausgestaltung der Erfindung liegt in einer einfachen Herstellung des Anschlusselementes 3 bei gleichzeitiger Bereitstellung einer komfortablen Schnittstelle zur elektrischen Kontaktierung (Anschlussstecker 20). Die Fußbereiche 7, 7', die Übergangsbereiche 9,11, der Brückenbereich 10 und der Anschlussstecker 20 sind einstückig ausgebildet. Das Anschlusselement 3 wird in einem planen Ausgangszustand bereitgestellt, in dem die als Übergangsbereich 9 und als Fußbereich 7 vorgesehenen Abschnitte innerhalb der Aussparung 21 angeordnet sind. Im Ausgangszustand sind der Übergangsbereich 11 und der Fußbereich 7' in der gleichen Ebene angeordnet wie der Brückenbereich 10. Der Anschlussstecker 20 ist im Ausgangszustand ebenfalls in der gleichen Ebene wie der Brückenbereich 10 angeordnet. Der als Fußbereich 7 und Übergangsbereich 9 vorgesehene Bereich kann vom Brückenbereich 10 getrennt werden, beispielsweise durch Ausstanzen, Laserbearbeitung oder Wasserstrahlbearbeitung, wobei eine Verbindung über die Verbindungskante zwischen Übergangsbereich 9 und Brückenbereich 10 bestehen bleibt. Der Anschlussstecker 20 wird um die Verbindungslinie zwischen Anschlussstecker 20 und Brückenbereich 10 in die dargestellt Position gebogen, wobei die im Ausgangszustand nach oben weisende Fläche dem Brückenbereich 10 zugewandt wird. Der Übergangsbereich 9 und der Fußbereich 7 werden über die Verbindungslinie zwischen Übergangsbereich 9 und Brückenbereich 10 in die dargestellte Position gebogen, wobei die im Ausgangszustand nach oben weisende Fläche anschließend die Unterseiten des Fußbereichs 7 und des Übergangsbereichs 9 bilden. Durch das Umbiegen des Übergangsbereichs 9 und des Fußbereich 7 wird die Aussparung 21 gebildet. Der Übergangsbereich 11 und der Fußbereich 7' werden ebenfalls aus dem planen Ausgangszustand in die dargestellt Position gebogen.

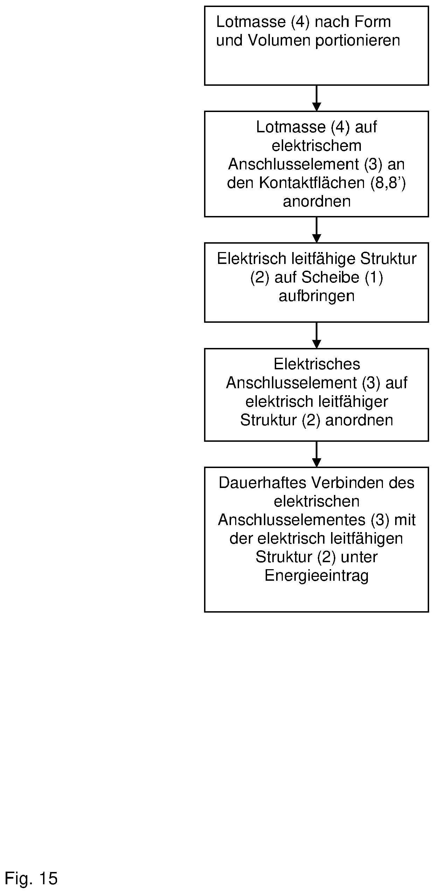

Fig. 15 zeigt detailliert ein erfindungsgemäßes Verfahren zur Herstellung einer Scheibe 1 mit elektrischem Anschlusselement 3. Dort wird ein Beispiel für das erfindungsgemäße Verfahren zur Herstellung einer Scheibe mit einem elektrischen Anschlusselement 3 dargestellt. Als erster Schritt ist es notwendig, die Lotmasse 4 nach Form und Volumen zu portionieren. Die portionierte Lotmasse 4 wird auf die Kontaktflächen 8 und 8' des elektrischen Anschlusselementes 3 angeordnet. Das elektrische Anschlusselement 3 wird mit der Lotmasse 4 auf der elektrisch leitfähigen Struktur 2 angeordnet. Es erfolgt eine dauerhafte Verbindung des elektrischen Anschlusselementes 3 mit der elektrisch leitfähigen Struktur 2 und dadurch mit der Scheibe 1 unter Energieeintrag.

### Beispiel

Testproben wurden angefertigt mit der Scheibe 1 (Dicke 3 mm, Breite 150 cm und Höhe 80 cm), der elektrisch leitfähigen Struktur 2 in Form einer Heizleiterstruktur, dem elektrischen Anschlusselement 3 gemäß Figur 1, der Silberschicht 5 auf den Kontaktflächen 8 und 8' des Anschlusselements 3 und der Lotmasse 4. Der Winkel zwischen der Oberfläche des Substrats 1 und der zum Substrat 1 hingewandten Fläche 9' des Übergangsbereichs 9 beziehungsweise zwischen der Oberfläche des Substrats 1 und der zum Substrat 1 hingewandten Fläche 11' des Übergangsbereichs 11 betrug α = 40°. Die Materialdicke des Anschlusselementes 3 betrug 0,8 mm. Das Anschlusselement 3 enthielt Stahl der Werkstoff-Nummer 1.4509 nach EN 10 088-2 (ThyssenKrupp Nirosta^{®} 4509). Die Kontaktflächen 8 und 8' des Anschlusselements 3 wiesen eine Breite von 4 mm und eine Länge von 4 mm auf. Die Lotmasse 4 wurde vorher als Plättchen mit festgelegter Schichtdicke, Volumen und Form auf den Kontaktflächen 8 und 8' des Anschlusselements 3 aufgebracht. Das Anschlusselement 3 wurde mit der angebrachten Lotmasse 4 auf der elektrisch leitfähigen Struktur 2 angebracht. Das Anschlusselement 3 wurde bei einer Temperatur von 200 °C und einer Behandlungsdauer von 2 Sekunden auf der elektrisch leitfähigen Struktur 2 angelötet. Ein Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde nur auf einer maximalen Austrittsbreite von b = 0,4 mm beobachtet. Die Ausmaße und Zusammensetzungen des elektrischen Anschlusselements 3, der Silberschicht 5 auf den Kontaktflächen 8 und 8' des Anschlusselements 3 und der Lotmasse 4 gehen aus der Tabelle 1 hervor. Durch die Anordnung der Lotmasse 4, vorgegeben durch das Anschlusselement 3 und die elektrisch leitfähige Struktur 2, wurden keine kritischen mechanischen Spannungen in der Scheibe 1 beobachtet. Die Verbindung der Scheibe 1 mit dem elektrischen Anschlusselement 3 war über die elektrisch leitfähige Struktur 2 dauerhaft stabil.

Bei sämtlichen Proben konnte bei einem Temperaturunterschied von +80 °C auf -30 °C beobachtet werden, dass kein Glassubstrat 1 brach oder Schäden aufwies. Es konnte gezeigt werden, dass kurz nach dem Anlöten diese Scheiben 1 mit angelöteten Anschlusselement 3 gegen plötzlichen Temperaturabfall stabil waren.

Des Weiteren wurden Testproben mit einer zweiten Zusammensetzung des elektrischen Anschlusselements 3 durchgeführt. Das Anschlusselement 3 enthielt dabei eine Eisen-Nickel-Kobalt-Legierung. Die Ausmaße und Zusammensetzungen des elektrischen Anschlusselements 3, der Silberschicht 5 auf den Kontaktflächen 8 und 8' des Anschlusselements 3 und der Lotmasse 4 gehen aus Tabelle 2 hervor. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 0,4 mm erhalten. Auch hier konnte beobachtet werden, dass bei einem Temperaturunterschied von +80 °C auf -30 °C kein Glassubstrat 1 brach oder Schäden aufwies. Es konnte gezeigt werden, dass kurz nach dem Anlöten diese Scheiben 1 mit angelötetem Anschlusselement 3 gegen plötzlichen Temperaturabfall stabil waren.

Des Weiteren wurden Testproben mit einer dritten Zusammensetzung des elektrischen Anschlusselements 3 durchgeführt. Das Anschlusselement 3 enthielt dabei eine Eisen-Nickel-Legierung. Die Ausmaße und Zusammensetzungen des elektrischen Anschlusselements 3, der Silberschicht 5 auf den Kontaktflächen 8 und 8' des Anschlusselements 3 und der Lotmasse 4 gehen aus Tabelle 3 hervor. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 0,4 mm erhalten. Auch hier konnte beobachtet werden, dass bei einem Temperaturunterschied von +80 °C auf -30 °C kein Glassubstrat 1 brach oder Schäden aufwies. Es konnte gezeigt werden, dass kurz nach dem Anlöten diese Scheiben 1 mit angelötetem Anschlusselement 3 gegen plötzlichen Temperaturabfall stabil waren.

**Tabelle 1**

| Bestandteile | Material | | Beispiel |
|---|---|---|---|
| Anschlusselement 3 | | | |
| | Stahl der Werkstoff-Nummer 1.4509 nach EN 10 088-2 mit der Zusammensetzung: | | |
| | | Eisen (Gew.-%) | 78,87 |
| | | Kohlenstoff (Gew.-%) | 0,03 |
| | | Chrom (Gew.-%) | 18,5 |
| | | Titan (Gew.-%) | 0,6 |
| | | Niob (Gew.-%) | 1 |
| | | Mangan (Gew.-%) | 1 |
| | CTE (coefficient of thermal expansion) (10⁻⁶/°C für 0 °C - 100 °C) | | 10 |
| | Differenz zwischen CTE Anschlusselement und Substrat (10⁻⁶/°C für 0 °C - 100 °C) | | 1,7 |
| | Dicke des Anschlusselements (m) | | 8,0 × 10⁻⁴ |
| | Winkel α (°) | | 40 |
| Benetzungsschicht 5 | | | |
| | Silber (Gew.-%) | | 100 |
| | Dicke der Schicht (m) | | 7,0 × 10⁻⁶ |
| Lotmasse 4 | | | |
| | Zinn (Gew.-%) | | 40 |
| | Wismut (Gew.-%) | | 57 |
| | Silber (Gew.-%) | | 3 |
| | Dicke der Lotschicht in (m) | | 250 × 10⁻⁶ |
| | Die Dicke der Benetzungsschicht und der Lotschicht (m) | | 257 × 10⁻⁶ |
| Glas Substrat 1 | | | |
| (Natron-Kalk-Glas) | | | |
| | CTE (10⁻⁶/°C für 0 °C - 320 °C) | | 8,3 |

**Tabelle 2**

| Bestandteile | Material | | Beispiel |
|---|---|---|---|
| Anschlusselement 3 | | | |
| | | Eisen (Gew.-%) | 54 |
| | | Nickel (Gew.-%) | 29 |
| | | Kobalt (Gew.-%) | 17 |
| | CTE (coefficient of thermal expansion) (10⁻⁶/°C für 0 °C - 100 °C) | | 5,1 |
| | Differenz zwischen CTE Anschlusselement und Substrat (10⁻⁶/°C für 0 °C - 100 °C) | | 3,2 |
| | Dicke des Anschlusselements (m) | | 8,0 × 10⁻⁴ |
| | Winkel α (°) | | 40 |
| Benetzungsschicht 5 | | | |
| | Silber (Gew.-%) | | 100 |
| | Dicke der Schicht (m) | | 7,0 × 10⁻⁶ |
| Lotmasse 4 | | | |
| | Zinn (Gew.-%) | | 40 |
| | Wismut (Gew.-%) | | 57 |
| | Silber (Gew.-%) | | 3 |
| | Dicke der Lotschicht in (m) | | 250 × 10⁻⁶ |
| | Die Dicke der Benetzungsschicht und der Lotschicht (m) | | 257 × 10⁻⁶ |
| Glas Substrat 1 | | | |
| (Natron-Kalk-Glas) | | | |
| | CTE (10⁻⁶/°C für 0 °C - 320 °C) | | 8,3 |

**Tabelle 3**

| Bestandteile | Material | | Beispiel |
|---|---|---|---|
| Anschlusselement 3 | | | |
| | | Eisen (Gew.-%) | 65 |
| | | Nickel (Gew.-%) | 35 |
| | CTE (coefficient of thermal expansion) (10⁻⁶/°C für 0 °C - 100 °C) | | 1,7 |
| | Differenz zwischen CTE Anschlusselement und Substrat (10⁻⁶/°C für 0 °C - 100 °C) | | 6,6 |
| | Dicke des Anschlusselements (m) | | 8,0 × 10⁻⁴ |
| | Winkel α (°) | | 40 |
| Benetzungsschicht 5 | | | |
| | Silber (Gew.-%) | | 100 |
| | Dicke der Schicht (m) | | 7,0 × 10⁻⁶ |
| Lotmasse 4 | | | |
| | Zinn (Gew.-%) | | 40 |
| | Wismut (Gew.-%) | | 57 |
| | Silber (Gew.-%) | | 3 |
| | Dicke der Lotschicht in (m) | | 250 × 10⁻⁶ |
| | Die Dicke der Benetzungsschicht und der Lotschicht (m) | | 257 × 10⁻⁶ |
| Glas Substrat 1 | | | |
| (Natron-Kalk-Glas) | | | |
| | CTE (10⁻⁶/°C für 0 °C - 320 °C) | | 8,3 |

### Vergleichsbeispiel 1

Das Vergleichsbeispiel wurde genauso durchgeführt wie das Beispiel. Das Anschlusselement enthielt Stahl der Werkstoff-Nummer 1.4509 nach EN 10 088-2 (ThyssenKrupp Nirosta^{®} 4509). Der Unterschied lag in der Form des Anschlusselements. Der Winkel α betrug nach dem Stand der Technik 90°. Damit konnten sich keine Kapillarkräfte an den Kanten der Kontaktflächen 8 und 8' ausbilden. Die Ausmaße und Bestandteile des elektrischen Anschlusselements 3, der Metallschicht auf den Kontaktflächen 8 und 8' des Anschlusselements 3 und der Lotmasse 4 gehen aus der Tabelle 4 hervor. Das Anschlusselement 3 wurde mit der elektrisch leitfähigen Struktur 2 wie im Beispiel mittels der Lotmasse 4 verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 0,5 mm erhalten.

Bei sämtlichen Proben konnte bei einem Temperaturunterschied von +80 °C auf -30 °C beobachtet werden, dass kein Glassubstrat 1 brach oder Schäden aufwies. Es konnte gezeigt werden, dass kurz nach dem Anlöten diese Scheiben 1 mit angelöteten Anschlusselement 3 gegen plötzlichen Temperaturabfall stabil waren. Allerdings wiesen sie im Vergleich zum Beispiel eine größere durchschnittliche Austrittsbreite b auf.

**Tabelle 4**

| Bestandteile | Material | | Vergleichsbeispiel |
|---|---|---|---|
| Anschlusselement 3 | Stahl der Werkstoff-Nummer 1.4509 nach EN 10 088-2 mit der Zusammensetzung: | | |
| | | Eisen (Gew.-%) | 78,87 |
| | | Kohlenstoff (Gew.-%) | 0,03 |
| | | Chrom (Gew.-%) | 18,5 |
| | | Titan (Gew.-%) | 0,6 |
| | | Niob (Gew.-%) | 1 |
| | | Mangan (Gew.-%) | 1 |
| | CTE (coefficient of thermal expansion) (10⁻⁶/°C für 0 °C - 100 °C) | | 10 |
| | Differenz zwischen CTE des Anschlusselements und des Substrats (10⁻⁶/°C für 0 °C - 100 °C) | | 1,7 |
| | Dicke des Anschlusselements (m) | | 8,0 × 10⁻⁴ |
| | Winkel α (°) | | 90 |
| Benetzungsschicht 5 | | | |
| | Silber (Gew.-%) | | 100 |
| | Dicke der Schicht (m) | | 7,0 × 10⁻⁶ |
| Lotmasse 4 | | | |
| | Zinn (Gew.-%) | | 40 |
| | Wismut (Gew.-%) | | 57 |
| | Silber (Gew.-%) | | 3 |
| | Dicke der Lotschicht in (m) | | 250 × 10⁻⁶ |
| | Die Dicke der Benetzungsschicht und der Lotschicht (m) | | 257 × 10⁻⁶ |
| Glas Substrat 1 | | | |
| (Natron-Kalk-Glas) | | | |
| | CTE (10⁻⁶/°C für 0 °C - 320 °C) | | 8,3 |

### Vergleichsbeispiel 2

Das Vergleichsbeispiel wurde genauso durchgeführt wie das Beispiel. Der Unterschied lag in der Verwendung eines anderen Materials für das Anschlusselement 3. Das Anschlusselement 3 bestand zu 100 Gew.-% aus Titan. Die Ausmaße und Bestandteile des elektrischen Anschlusselements 3, der Metallschicht auf den Kontaktflächen 8 und 8' des Anschlusselements 3 und der Lotmasse 4 gehen aus der Tabelle 5 hervor. Das Anschlusselement 3 wurde mit der elektrisch leitfähigen Struktur 2 nach herkömmlichen Verfahren mittels der Lotmasse 4 verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 2 mm bis 3 mm erhalten. Die große Austrittsbreite führte zu kritischen mechanischen Spannungen in der Scheibe.

Bei einem plötzlichen Temperaturunterschied von +80 °C auf -30 °C wurde beobachtet, dass die Glassubstrate 1 kurz nach dem Anlöten überwiegend Schäden aufwiesen.

**Tabelle 5**

| Bestandteile | Material | Vergleichsbeispiel |
|---|---|---|
| Anschlusselement 3 | | |
| | Titan (Gew.-%) | 100 |
| | CTE (coefficient of thermal expansion) (10⁻⁶/°C für 0 °C - 100 °C) | 8,80 |
| | Differenz zwischen CTE des Anschlusselements und des Substrats (10⁻⁶/°C für 0 °C - 100 °C) | 0,5 |
| | Dicke des Anschlusselements (m) | 8,0 × 10⁻⁴ |
| | Winkel α (°) | 40 |
| Benetzungsschicht 5 | | |
| | Silber (Gew.-%) | 100 |
| | Dicke der Schicht (m) | 7,0 × 10⁻⁶ |
| Lotmasse 4 | | |
| | Zinn (Gew.-%) | 40 |
| | Wismut (Gew.-%) | 57 |
| | Silber (Gew.-%) | 3 |
| | Dicke der Lotschicht in (m) | 250 × 10⁻⁶ |
| | Die Dicke der Benetzungsschicht und der Lotschicht (m) | 257 × 10⁻⁶ |
| Glas Substrat 1 | | |
| (Natron-Kalk-Glas) | | |
| | CTE (10⁻⁶/°C für 0 °C - 320 °C) | 8,3 |

### Vergleichsbeispiel 3

Das Vergleichsbeispiel wurde genauso durchgeführt wie das Beispiel. Der Unterschied lag in der Verwendung eines anderen Materials für das Anschlusselement 3. Das Anschlusselement 3 bestand zu 100 Gew.-% aus Kupfer. Die Ausmaße und Bestandteile des elektrischen Anschlusselements 3, der Metallschicht auf den Kontaktflächen 8 und 8' des Anschlusselements 3 und der Lotmasse 4 gehen aus der Tabelle 6 hervor. Das Anschlusselement 3 wurde mit der elektrisch leitfähigen Struktur 2 nach herkömmlichen Verfahren mittels der Lotmasse 4 verlötet. Beim Austritt der Lotmasse 4 aus dem Zwischenraum zwischen dem elektrischen Anschlusselement 3 und der elektrisch leitfähigen Struktur 2, die eine Schichtdicke t von 50 µm überstieg, wurde eine durchschnittliche Austrittsbreite b = 2 mm bis 3 mm erhalten. Der große Unterschied der thermischen Ausdehnungskoeffizienten zwischen Anschlusselement 3 und Substrat 1 sowie die große Austrittsbreite führten zu kritischen mechanischen Spannungen in der Scheibe.

Bei einem plötzlichen Temperaturunterschied von +80 °C auf -30 °C wurde beobachtet, dass die Glassubstrate 1 kurz nach dem Anlöten überwiegend Schäden aufwiesen.

**Tabelle 6**

| Bestandteile | Material | Vergleichsbeispiel |
|---|---|---|
| Anschlusselement 3 | | |
| | Kupfer | 100 |
| | CTE (coefficient of thermal expansion) (10⁻⁶/°C für 0 °C - 100 °C) | 16 |
| | Differenz zwischen CTE des Anschlusselements und des Substrats (10⁻⁶/°C für 0 °C - 100 °C) | 7,7 |
| | Dicke des Anschlusselements (m) | 8,0 × 10⁻⁴ |
| | Winkel α (°) | 40 |
| Benetzungsschicht 5 | | |
| | Silber (Gew.-%) | 100 |
| | Dicke der Schicht (m) | 7,0 × 10⁻⁶ |
| Lotmasse 4 | | |
| | Zinn (Gew.-%) | 40 |
| | Wismut (Gew.-%) | 57 |
| | Silber (Gew.-%) | 3 |
| | Dicke der Lotschicht in (m) | 250 × 10⁻⁶ |
| | Die Dicke der Benetzungsschicht und der Lotschicht (m) | 257 × 10⁻⁶ |
| Glas Substrat 1 | | |
| (Natron-Kalk-Glas) | | |
| | CTE (10⁻⁶/°C für 0 °C - 320 °C) | 8,3 |

Die Unterschiede aus den vorstehenden Tabellen 1 bis 6, die Vorteile des erfindungsgemäßen Anschlusselementes 3 und die Beobachtungen gehen aus den Tabellen 7 und 8 hervor.

**Tabelle 7**

| | Erfindungsgemäße Ausführung, Beispiel | | |
|---|---|---|---|
| | Tabelle 1 | Tabelle 2 | Tabelle 3 |
| Material | Stahl der Werkstoff-Nummer 1.4509 nach EN 10 088-2 | Eisen (54 Gew.-%) Nickel (29 Gew.-%) Kobalt (17 Gew.-%) | Eisen (65 Gew.-%) Nickel (35 Gew.-%) |
| CTE (coefficient of thermal expansion) des Anschlusselements (10⁻⁶/°C für 0 °C - 100 °C) | 10 | 5,1 | 1,7 |
| Differenz zwischen CTE des Anschlusselements und des Substrats (10⁻⁶/°C für 0 °C - 100 °C) | 1,7 | 3,2 | 6,6 |
| Winkel α (°) | 40 | 40 | 40 |
| Austrittsbreite b (mm) | 0,4 | 0,4 | 0,4 |
| Beobachtung | stabil gegen plötzlichen Temperaturabfall | stabil gegen plötzlichen Temperaturabfall | stabil gegen plötzlichen Temperaturabfall |

**Tabelle 8**

| | Vergleichsbeispiel 1 | Vergleichsbeispiel 2 | Vergleichsbeispiel 3 |
|---|---|---|---|
| | Tabelle 4 | Tabelle 5 | Tabelle 6 |
| Material | Stahl der Werkstoff-Nummer 1.4509 nach EN 10 088-2 | Titan (100 Gew.-%) | Kupfer (100 Gew.-%) |
| CTE (coefficient of thermal expansion) des Anschlusselements (10⁻⁶/°C für 0 °C - 100 °C) | 10 | 8,8 | 16 |
| Differenz zwischen CTE des Anschlusselements und des Substrats (10⁻⁶/°C für 0 °C - 100 °C) | 1,7 | 0,5 | 7,7 |
| Winkel α (°) | 90 | 40 | 40 |
| Austrittsbreite b (mm) | 0,5 | 2-3 | 2-3 |
| Beobachtung | stabil gegen plötzlichen Temperaturabfall | Substrate überwiegend beschädigt | Substrate überwiegend beschädigt |

Es hat sich gezeigt, dass erfindungsgemäße Scheiben mit Glassubstraten 1 und erfindungsgemäßen elektrischen Anschlusselementen 3 eine geringere Austrittsbreite und eine bessere Stabilität gegen plötzliche Temperaturunterschiede aufwiesen.

Dieses Ergebnis war für den Fachmann unerwartet und überraschend.

### Bezugszeichenliste

- (1): Scheibe
- (2): Elektrisch leitfähige Struktur
- (3): Elektrisches Anschlusselement
- (4): Lotmasse
- (5): Benetzungsschicht
- (6): Ausgleichskörper
- (7): Fußbereich des elektrischen Anschlusselements 3
- (7'): Fußbereich des elektrischen Anschlusselements 3
- (8): Kontaktfläche des Anschlusselements 3
- (8'): Kontaktfläche des Anschlusselements 3
- (9): Übergangsbereich des elektrischen Anschlusselements 3
- (9'): zum Substrat 1 hingewandte Fläche des Übergangsbereichs 9
- (10): Brückenbereich des elektrischen Anschlusselements 3
- (11): Übergangsbereich des elektrischen Anschlusselements 3
- (11'): zum Substrat 1 hingewandte Fläche des Übergangsbereichs 11
- (12): Tangentialebene der Fläche 9'
- (16): Verbindung von Kontaktfläche 8 und Fläche 9' des Übergangsbereichs 9
- (16'): Verbindung von Kontaktfläche 8' und Fläche 11' des Übergangsbereichs 11
- (17): Teilbereich des Brückenbereichs 10
- (17'): Teilbereich des Brückenbereichs 10
- (18): Teilbereich des Brückenbereichs 10
- (18'): Teilbereich des Brückenbereichs 10
- (19): Abstandshalter
- (20): Anschlussstecker
- (21): Aussparung
- (22): Kontakterhebung

- α₁: Winkel zwischen Oberfläche des Substrats 1 und Fläche 9'
- α₂: Winkel zwischen Oberfläche des Substrats 1 und Fläche 11'
- β₁: Winkel zwischen Oberfläche des Substrats 1 und Fläche 9'
- β₂: Winkel zwischen Oberfläche des Substrats 1 und Fläche11'
- γ: Winkel zwischen den planen Abschnitten eines gewinkelten Brückenelements 10
- b: maximale Austrittsbreite der Lotmasse
- t: Grenzdicke der Lotmasse
- h: Höhe des Abstandshalters 19
- l: Breite des Abstandshalters 19

- A-A': Schnittlinie
- B-B': Schnittlinie
- C-C': Schnittlinie

## Patentansprüche

1. Eine Scheibe mit mindestens einem elektrischen Anschlusselement, umfassend:
- ein Substrat (1),
- eine elektrisch leitfähige Struktur (2) auf einem Bereich des Substrats (1),
- eine Schicht einer bleifreien Lotmasse (4) auf einem Bereich der elektrisch leitfähigen Struktur (2) und
- ein Anschlusselement (3) auf der Lotmasse (4), wobei das Anschlusselement (3) zumindest einen chromhaltigen Stahl mit einem Anteil an Chrom von größer oder gleich 10,5 Gew.-% und einem thermischen Ausdehnungskoeffizienten von 9 × 10⁻⁶/°C bis 13 × 10⁻⁶/°C enthält,
- das Anschlusselement (3) einen ersten und einen zweiten Fußbereich (7,7'), einen ersten und einen zweiten Übergangsbereich (9,11) und einen Brückenbereich (10) zwischen dem ersten und zweiten Übergangsbereich (9,11) enthält,
- sich an der Unterseite des ersten und zweiten Fußbereichs (7,7') eine erste und eine zweite Kontaktfläche (8,8') befinden,
- die erste und zweite Kontaktfläche (8,8') und die zum Substrat (1) hingewandten Flächen (9',11') des ersten und zweiten Übergangsbereichs (9,11) durch die Lotmasse (4) mit der elektrisch leitfähigen Struktur (2) verbunden sind und
- der Winkel zwischen der Oberfläche des Substrats (1) und jeder der Tangentialebenen (12) der zum Substrat (1) hingewandten Flächen (9',11') der Übergangsbereiche (9,11) < 90° beträgt.

2. Scheibe nach Anspruch 1, wobei das Substrat (1) Glas, bevorzugt Flachglas, Floatglas, Quarzglas, Borosilikatglas, Kalk-Natron-Glas, oder Polymere, bevorzugt Polyethylen, Polypropylen, Polycarbonat, Polymethylmethacrylat und / oder Gemische davon, enthält.

3. Scheibe nach Anspruch 1 oder 2, wobei der Winkel zwischen der Oberfläche des Substrats (1) und jeder der Tangentialebenen (12) der zum Substrat (1) hingewandten Flächen (9',11') der Übergangsbereiche (9,11) zwischen 2° und 75°, bevorzugt zwischen 5° und 50° beträgt.

4. Scheibe nach einem der Ansprüche 1 bis 3, wobei der erste Übergangsbereich (9), der zweite Übergangsbereich (11) und der Brückenbereich (10) abschnittsweise plan ausgeformt sind.

5. Scheibe nach einem der Ansprüche 1 bis 3, wobei der erste Übergangsbereich (9), der zweite Übergangsbereich (11) und / oder der Brückenbereich (10) gekrümmt sind und bevorzugt die gleiche Krümmungsrichtung haben.

6. Scheibe nach einem der Ansprüche 1 bis 3, wobei der erste Übergangsbereiche (9) und der zweite Übergangsbereich (11) plan ausgeformt sind und der Brückenbereich (10) gewinkelt ausgeformt ist.

7. Scheibe nach einem der Ansprüche 1 bis 6, wobei an den Kontaktflächen (8,8') Abstandshalter (19) angeordnet sind.

8. Scheibe nach einem der Ansprüche 1 bis 7, wobei das Anschlusselement (3) zumindest 50 Gew.-% bis 89,5 Gew.-% Eisen, 10,5 Gew.-% bis 20 Gew.-% Chrom, 0 Gew.-% bis 1 Gew.-% Kohlenstoff, 0 Gew.-% bis 5 Gew.-% Nickel, 0 Gew.-% bis 2 Gew.-% Mangan, 0 Gew.-% bis 2,5 Gew.-% Molybdän oder 0 Gew.-% bis 1 Gew.-% Titan enthält.

9. Scheibe nach einem der Ansprüche 1 bis 8, wobei die Lotmasse (4) Zinn und Wismut, Indium, Zink, Kupfer, Silber oder Zusammensetzungen davon enthält.

10. Scheibe nach Anspruch 9, wobei der Anteil an Zinn in der Lotzusammensetzung (4) 3 Gew.-% bis 99,5 Gew.-% beträgt und der Anteil von Wismut, Indium, Zink, Kupfer, Silber oder Zusammensetzungen davon 0,5 Gew.-% bis 97 Gew.-% beträgt.

11. Scheibe nach einem der Ansprüche 1 bis 10, wobei das Anschlusselement (3) mit Nickel, Zinn, Kupfer und / oder Silber beschichtet ist, bevorzugt mit 0,1 µm bis 0,3 µm Nickel und / oder 3 µm bis 20 µm Silber.

12. Verfahren zur Herstellung einer Scheibe mit mindestens einem elektrischen Anschlusselement (3) nach einem der Ansprüche 1 bis 11, wobei
a) bleifreie Lotmasse (4) auf die Kontaktflächen (8,8') des Anschlusselements (3) als Plättchen mit festgelegter Schichtdicke, Volumen und Form angeordnet und aufgebracht wird, wobei das Anschlusselement (3) zumindest einen chromhaltigen Stahl mit einem Anteil an Chrom von größer oder gleich 10,5 Gew.-% und einem thermischen Ausdehnungskoeffizienten von 9 × 10⁻⁶/°C bis 13 × 10⁻⁶/°C enthält,
b) eine elektrisch leitfähige Struktur (2) auf einem Bereich eines Substrats (1) aufgebracht wird,
c) das Anschlusselement (3) mit der Lotmasse (4) auf der elektrisch leitfähigen Struktur (2) angeordnet wird und
d) das Anschlusselement (3) mit der elektrisch leitfähigen Struktur (2) verlötet wird.

13. Verwendung einer Scheibe mit mindestens einem elektrischen Anschlusselement nach einem der Ansprüche 1 bis 11, für Fahrzeuge mit elektrisch leitfähigen Strukturen, bevorzugt mit Heizleitern und/oder Antennenleitern.

## Claims

1. A pane with at least one electrical connection element, comprising:
- a substrate (1),
- an electrically conductive structure (2) on a region of the substrate (1),
- a layer of a leadfree solder material (4) on a region of the electrically conductive structure (2), and
- a connection element (3) on the solder material (4), wherein the connection element (3) contains at least a chromium-containing steel with a proportion of chromium greater than or equal to 10.5 wt.-% and a coefficient of thermal expansion of 9 × 10⁻⁶/°C to 13 × 10⁻⁶/°C,
- the connection element (3) contains a first and a second foot region (7,7'), a first and a second transition region (9,11), and a bridge region (10) between the first and second transition region (9,11),
- a first and a second contact surface (8,8') are located on the bottom of the first and second foot regions (7,7'),
- the first and second contact surface (8,8') and the surfaces (9',11') of the first and second transition regions (9,11) facing the substrate (1) are connected to the electrically conductive structure (2) by the solder material (4), and
- the angle between the surface of the substrate (1) and each of the tangent planes (12) of the surfaces (9',11') of the transition regions (9,11) facing the substrate (1) is < 90°.

2. Pane according to claim 1, wherein the substrate (1) contains glass, preferably flat glass, float glass, quartz glass, borosilicate glass, soda lime glass, or polymers, preferably polyethylene, polypropylene, polycarbonate, polymethyl methacrylate, and / or mixtures thereof.

3. Pane according to claim 1 or 2, wherein the angle between the surface of the substrate (1) and each of the tangent planes (12) of the surfaces (9',11') of the transition regions (9,11) facing the substrate (1) is between 2° and 75°, preferably between 5° and 50°.

4. Pane according to one of claims 1 through 3, wherein the first transition region (9), the second transition region (11), and the bridge region (10) are shaped flat in sections.

5. Pane according to one of claims 1 through 3, wherein the first transition region (9), the second transition region (11), and / or the bridge region (10) are curved and have, preferably, the same direction of curvature.

6. Pane according to one of claims 1 through 3, wherein the first transition region (9) and the second transition region (11) are shaped flat and the bridge region (10) is shaped angled.

7. Pane according to one of claims 1 through 6, wherein spacers (19) are arranged on the contact surfaces (8, 8').

8. Pane according to one of claims 1 through 7, wherein the connection element (3) contains at least 50 wt.-% to 89.5 wt.-% iron, 10.5 wt.-% to 20 wt.-% chromium, 0 wt.-% to 1 wt.-% carbon, 0 wt.-% to 5 wt.-% nickel, 0 wt.-% to 2 wt.-% manganese, 0 wt.-% to 2.5 wt.-% molybdenum, or 0 wt.-% to 1 wt.-% titanium.

9. Pane according to one of claims 1 through 8, wherein the solder material (4) contains tin and bismuth, indium, zinc, copper, silver, or compositions thereof.

10. Pane according to claim 9, wherein the proportion of tin in the solder composition (4) is 3 wt.-% to 99.5 wt.-% and the proportion of bismuth, indium, zinc, copper, silver, or compositions thereof is 0.5 wt.-% to 97 wt.-%.

11. Pane according to one of claims 1 through 10, wherein the connection element (3) is coated with nickel, tin, copper, and / or silver, preferably with 0.1 µm to 0.3 µm nickel and / or 3 µm to 20 µm silver.

12. Method for production of a pane with at least one electrical connection element (3) according to one of claims 1 through 11, wherein
a) leadfree solder material (4) is arranged and applied on the contact surfaces (8, 8') of the connection element (3) as a platelet with a fixed layer thickness, volume, and shape, wherein the connection element (3) contains at least one chromium-containing steel with a proportion of chromium greater than or equal to 10.5 wt.-% and a coefficient of thermal expansion of 9 × 10⁻⁶/°C to 13 × 10⁻⁶/°C,
b) an electrically conductive structure (2) is applied to a region of a substrate (1),
c) the connection element (3) with the solder material (4) is arranged on the electrically conductive structure (2), and
d) the connection element (3) is soldered to the electrically conductive structure (2).

13. Use of a pane with at least one electrical connection element according to one of claims 1 through 11, for vehicles with electrically conductive structures, preferably with heating conductors and/or antenna conductors.

## Revendications

1. Vitre comportant au moins un élément de connexion électrique, comprenant :
- un substrat (1),
- une structure électriquement conductrice (2) sur une région du substrat (1),
- une couche d'un matériau de soudure sans plomb (4) sur une région de la structure électriquement conductrice (2), et
- un élément de connexion (3) sur le matériau de soudure (4), dans lequel l'élément de connexion (3) contient au moins un acier contenant du chrome avec une proportion de chrome supérieure ou égale à 10,5 % en poids et un coefficient de dilatation thermique de 9 × 10⁻⁶/°C à 13 × 10⁻⁶/°C,
- l'élément de connexion (3) contient une première et une seconde région de pied (7, 7'), une première et une seconde région de transition (9, 11), et une région de pont (10) entre la première et la seconde région de transition (9, 11),
- une première et une seconde surface de contact (8, 8') sont situées sur le fond des première et seconde régions de pied (7, 7'),
- les première et seconde surfaces de contact (8, 8') et les surfaces (9', 11') des première et seconde régions de transition (9, 11) faisant face au substrat (1) sont connectées à la structure électriquement conductrice (2) par le matériau de soudure (4), et
- l'angle entre la surface du substrat (1) et chacun des plans tangents (12) des surfaces (9', 11') des régions de transition (9, 11) faisant face au substrat (1) est < 90°.

2. Vitre selon la revendication 1, dans laquelle le substrat (1) contient du verre, de préférence du verre plat, du verre flotté, du verre de quartz, du verre borosilicate, du verre sodocalcique, ou des polymères, de préférence du polyéthylène, du polypropylène, du polycarbonate, du polyméthacrylate de méthyle, et/ou des mélanges de ceux-ci.

3. Vitre selon la revendication 1 ou 2, dans laquelle l'angle entre la surface du substrat (1) et chacun des plans tangents (12) des surfaces (9', 11') des régions de transition (9, 11) faisant face au substrat (1) est compris entre 2° et 75°, de préférence entre 5° et 50°.

4. Vitre selon l'une des revendications 1 à 3, dans laquelle la première région de transition (9), la deuxième région de transition (11) et la région de pont (10) ont une forme plate par sections.

5. Vitre selon l'une des revendications 1 à 3, dans laquelle la première région de transition (9), la deuxième région de transition (11), et/ou la région de pont (10) sont incurvées et ont, de préférence, la même direction de courbure.

6. Vitre selon l'une des revendications 1 à 3, dans laquelle la première région de transition (9) et la deuxième région de transition (11) sont de forme plate et la région de pont (10) est de forme angulaire.

7. Vitre selon l'une des revendications 1 à 6, dans laquelle des entretoises (19) sont disposées sur les surfaces de contact (8, 8').

8. Vitre selon l'une des revendications 1 à 7, dans laquelle l'élément de liaison (3) contient au moins 50 % en poids à 89,5 % en poids de fer, 10,5 % en poids à 20 % en poids de chrome, 0 % en poids à 1 % en poids de carbone, 0 % en poids à 5 % en poids de nickel, 0 % en poids à 2 % en poids de manganèse, 0 % en poids à 2,5 % en poids de molybdène ou 0 % en poids à 1 % en poids de titane.

9. Vitre selon l'une des revendications 1 à 8, dans laquelle le matériau de soudure (4) contient de l'étain et du bismuth, de l'indium, du zinc, du cuivre, de l'argent, ou des compositions de ceux-ci.

10. Vitre selon la revendication 9, dans laquelle la proportion d'étain dans la composition de soudure (4) est de 3 % en poids à 99,5 % en poids et la proportion de bismuth, d'indium, de zinc, de cuivre, d'argent ou de leurs compositions est de 0,5 % en poids à 97 % en poids.

11. Vitre selon l'une des revendications 1 à 10, dans laquelle l'élément de connexion (3) est revêtu de nickel, d'étain, de cuivre et/ou d'argent, de préférence de 0,1 µm à 0,3 µm de nickel et/ou de 3 µm à 20 µm d'argent.

12. Procédé de fabrication d'une vitre avec au moins un élément de connexion électrique (3) selon l'une des revendications 1 à 11, dans lequel
a) un matériau de soudure sans plomb (4) est disposé et appliqué sur les surfaces de contact (8, 8') de l'élément de connexion (3) sous forme de plaquette avec une épaisseur de couche, un volume et une forme fixes, l'élément de connexion (3) contenant au moins un acier contenant du chrome avec une proportion de chrome supérieure ou égale à 10,5 % en poids et un coefficient de dilatation thermique de 9 × 10⁻⁶/°C à 13 × 10⁻⁶/°C,
b) une structure électriquement conductrice (2) est appliquée sur une région d'un substrat (1),
c) l'élément de connexion (3) avec le matériau de soudure (4) est disposé sur la structure électriquement conductrice (2), et
d) l'élément de connexion (3) est soudé à la structure électriquement conductrice (2).

13. Utilisation d'une vitre avec au moins un élément de connexion électrique selon l'une des revendications 1 à 11, pour des véhicules avec des structures électriquement conductrices, de préférence avec des conducteurs de chauffage et/ou des conducteurs d'antenne.
